# EUROPEAN PATENT SPECIFICATION

(11) **EP 4 311 382 B1**
(45) Date of publication and mention of the grant of the patent: **01.07.2026**
(21) Application number: 22902503.6
(22) Date of filing: 21.10.2022
(51) Int. Cl.: H05K 3/46, H05K 3/40, H05K 3/24, H05K 3/22, H05K 3/00, H05K 1/02, H05K 1/09, B33Y 10/00, B33Y 70/10, B33Y 80/00

(54) **3D PRINTING PREPARATION METHOD FOR HIGH-PRECISION MULTILAYER CIRCUIT BOARD**
3D-DRUCKHERSTELLUNGSVERFAHREN FÜR HOCHPRÄZISE MEHRSCHICHTIGE LEITERPLATTE
PROCÉDÉ DE PRÉPARATION D'IMPRESSION 3D D'UNE CARTE DE CIRCUIT IMPRIMÉ MULTICOUCHE DE HAUTE PRÉCISION

(30) Priority: 08.06.2022 CN 202210640826
(43) Date of publication of application: 24.01.2024
(73) Proprietor: ENOVATE3D (HANGZHOU) TECHNOLOGY DEVELOPMENT CO., LTD., Hangzhou, Zhejiang 310051 (CN)
(72) Inventor: CAI, Wangcan, Hangzhou Zhejiang 310051 (CN); LI, Saifeng, Hangzhou Zhejiang 310051 (CN); ZHOU, Nanjia, Hangzhou Zhejiang 310051 (CN)
(74) Representative: Fezzardi, Antonio
(86) International application number: PCT/CN2022/126587
(87) International publication number: WO 2023/236412

(56) References cited:
- WO-A1-2009/119600
- WO-A1-2018/136036
- CN-A- 107 846 790
- CN-A- 110 430 666
- CN-A- 111 613 888
- CN-A- 112 969 303
- CN-A- 114 745 875
- US-A1- 2006 292 769
- US-A1- 2009 025 215
- US-A1- 2009 266 582
- US-B1- 11 066 296

## Description

### TECHNICAL FIELD

The present disclosure belongs to the technical field of printed circuit board preparation, and particularly relates to a high-precision multilayer printed circuit board (PCB) and a 3D printing preparation method thereof.

### BACKGROUND ART

Multilayer printed circuit boards (PCBs) are commonly used in an IC carrier, a package substrate, a printed circuit board (PCB), a low temperature co-fired ceramic (LTCC) substrate and the like, which are the structural basis of electronic applications and products. Active devices (such as a power metal oxide semiconductor (MOS), a transistor and an IC chip) and various passive devices (such as a filter, a transformer, a resistor, a capacitor and an inductor) need to be assembled or embedded into the multilayer PCBs after being subjected to certain packaging processes. These PCBs further need to be further assembled in a packaging procedure at the next lower level to form a packaging system. Therefore, the multilayer PCBs play an important role in electrical connection, assembly connection and structure protection of different components and parts. Electrical, thermal and mechanical factors generated by devices and packaging need to be fully considered in design and manufacture of the multilayer PCBs. Various preparation technologies of the multilayer PCBs have been developed in the electronics industry for years to adapt to the design and application of products.

Conventional preparation technologies of the multilayer PCBs mainly include a thin film technology, a thick film technology and an organic laminated sheet technology. Circuit pattern transfer is done generally through photoetching + developing + electroless plating/electroplating, vapor deposition, screen printing or other methods according to different types of PCBs (such as the IC carrier, package substrate, PCB and LTCC substrate), different materials (such as organic and inorganic materials) and different requirements for interconnect precision. Through holes are formed by mechanical punching/drilling, laser boring, chemical etching, plasma etching or other methods, and plated by electroplating, screen printing or other methods. Single layers are overlaid and combined through vapor deposition, spin coating, stacked cofiring, laminating or other methods to form a multilayer structure. Such processes are widely applied in industries. However, the production costs and time of the multilayer PCBs are increased greatly due to complicated processes, requirements for multiple masks, expensive equipment, serious waste of materials and other factors.

In recent years, with the progress of 3D printing processes, compared with the conventional preparation process of the multilayer PCBs, the 3D process demonstrated a huge potential in shortening the development and implementation periods of new products and reducing the NRE (non-recurring engineering) cost. Some 3D printing processes based on inkjet or aerosol jet are limited in application to multilayer and high-density interconnect PCBs due to larger line width (ranging from dozens to hundreds of microns), large thickness of insulating layers (the minimum thickness is about 35 µm) and oversized vertical interconnect structure (hundreds of microns). These 3D printing processes can only be used for preparing PCBs with low requirements for the number of layers and interconnect precision. Some 3D printing processes based on fused deposition modeling (FDM) can only be used for preparing insulating layers made from special materials due to limitations to wire rods and melting technology, and the FDM printed surface quality is poor. The circuit layers and vertical interconnect structure need to be completed by other non-printing methods, resulting in low interconnect precision. In some 3D printing processes based on selective laser sintering (SLS), selective laser melting (SLM), electron beam selective melting (EBSM) or direct metal laser sintering (DMLS), as metal sintering or melting by using a high energy source is required after coating or spraying, these processes are lower in metal machining precision and not applicable for the preparation of precision multilayer PCBs. There are also some schemes of improving the printing precision through combination of an extrusion-based 3D printing method with corresponding slurry. For example, the Chinese patent with a publication number of CN109534767A has disclosed a slurry used for extrusion-based 3D white marble powder printing and a preparation method thereof. The slurry has a high solid content and good shearing performance, and is suitable for an extrusion-based 3D printing process. At room temperature, the slurry is gradually dried and cured in a 3D printing process, thereby obtaining a molded part of higher precision without collapsing. For another example, the Chinese patent with a publication number of CN107365158A has provided a paste with excellent stability and shear thinning characteristics, for which the paste can be smoothly extruded from a syringe needle and can still maintain a linear shape and a certain span after being deposited on a substrate. The paste has excellent molding performance, thereby improving the precision.

US 2006/292769A1 discloses a multilayered structure forming method which includes disposing a dummy post on a first insulating pattern as a first inkjet process, disposing a second insulating pattern on the first insulating pattern as a second inkjet process so as to allow the second insulating pattern to surround a side surface of the dummy post, and disposing a first conductive pattern on the second insulating pattern a third inkjet process so as to connect the first conductive pattern to the dummy post. In this method, the first inkjet process includes a process for ejecting a functional liquid containing a first conductive material having high adhesiveness to the first conductive pattern onto the first insulating pattern.

US 2009/025215 Al discloses a method of manufacturing a multilayer wiring structure. The method comprises a step of forming a via post on a first metal wiring element, a step of printing an interlayer insulation film on the first metal wiring element, with use of a screen mask having a non-ejection area slightly larger than a head of the via post, such that the interlayer insulation film has an upper surface at the level lower than the head of the via post, while generally aligning the non-ejection area with the head of the via post, a step of curing the interlayer insulation film, and a step of forming a second metal wiring element in contact with the via post on the interlayer insulation film such that the first metal wiring element and the second metal wiring element are connected through the via post.

US 2009/266582 Al discloses a three-dimensional circuit board which is formed by comprising a board, a first wiring-electrode group provided on a plurality of steps above the board, and a second wiring-electrode connected to the first wiring-electrode group at least in an altitude direction, in which at least a connecting portion between the first wiring-electrode group and the second wiring-electrode is integrated in a continuously identical shape.

WO 2009/119600 A1 discloses a laminated wiring board, which prevents displacement of an electronic component embedded by an embedding member such as prepreg that is sandwiched between both substrates, and thereby improves reliability in electrical connection between an electrode of the electronic component and an external electrode connected thereto. For connecting a conductor circuit formed in a first substrate and a resistor which is an electric component, conductors, which are made of conductive pastes filled within via holes formed in the first substrate, is connected so that each of the electrodes of the resistor which is an electronic component is connected through two or more of the conductors per electrode. The conductors continuous with each electrode are provided in a straight line in a short-side direction which is perpendicular to a longitudinal direction of the resistor, and are provided in symmetric positions about an axis in the longitudinal direction of the resistor.

### SUMMARY OF THE INVENTION

### TECHNICAL PROBLEM

Circuit pattern transfer is done generally through photoetching + developing + electroless plating/electroplating, vapor deposition, screen printing or other methods according to different types of PCBs (such as the IC carrier, package substrate, PCB and LTCC substrate), different materials (such as organic and inorganic materials) and different requirements for interconnect precision. Through holes are formed by mechanical punching/drilling, laser boring, chemical etching, plasma etching or other methods, and plated by electroplating, screen printing or other methods. Single layers are overlaid and combined through vapor deposition, spin coating, stacked cofiring, laminating or other methods to form a multilayer structure. Such processes are widely applied in industries. However, the production costs and time of the multilayer printed circuit boards are increased greatly due to complicated processes, requirements for multiple masks, expensive equipment, serious waste of materials and other factors.

In recent years, with the progress of 3D printing processes, compared with the conventional preparation process of the multilayer PCBs, the 3D processes demonstrated a huge potential in shortening the development and implementation periods of new products and reducing the NRE (non-recurring engineering) cost. Some 3D printing processes based on inkjet or aerosol jet are limited in application to multilayer and high-density interconnect PCBs due to larger line width (ranging from dozens to hundreds of microns), large thickness of insulating layers (the minimum thickness is about 35 µm) and oversized vertical interconnect structure (hundreds of microns). These 3D printing processes can only be used for preparing PCBs with low requirements for the number of layers and interconnect precision. Some 3D printing processes based on fused deposition modeling (FDM) can only be used for preparing insulating layers made from special materials due to limitations to wire rods and melting technology, and the FDM printed surface quality is poor. The circuit layers and vertical interconnect structure need to be completed by other non-printing methods, resulting in low interconnect precision. In some 3D printing processes based on selective laser sintering (SLS), selective laser melting (SLM), electron beam selective melting (EBSM) or direct metal laser sintering (DMLS), as metal sintering or melting by using a high energy source is required after coating or spraying, these processes are lower in metal machining precision and not applicable for preparation of precision multilayer PCBs.

### SOLUTIONS TO PROBLEMS

### TECHNICAL SOLUTIONS

In order to solve the above problems in the prior art, the present disclosure provides a 3D printing preparation method of a high-precision multilayer PCB, by which the high-precision multilayer PCB with high interconnect precision can be prepared as defined in appended claim 1.

Preferred embodiments are defined in the appended dependent claims.

### BENEFICIAL EFFECTS

According to the present disclosure, the high-precision multilayer PCB with high interconnect precision is fabricated by the extrusion-based 3D printing method, thereby improving the interconnect precision of the multilayer PCB.

The 3D printing preparation method of the high-precision multilayer PCB according to the present disclosure is applicable for the slurry of different dielectric materials and different metal materials.

The nanoscale metal slurry with shear thinning characteristics is extruded from the extrusion nozzle to form the three-dimensional circuit layer on the upper surface of the substrate. As the nanoscale metal slurry has shear thinning characteristics, the three-dimensional circuit layers are high in printing precision. A line width in the three-dimensional circuit layers may range from 1 µm to 150 µm, line spacing may range from 1 µm to 150 µm, a size of the vertical interconnect structure may range from 20 µm to 150 µm, and spacing between the vertical interconnect structures may range from 20 µm to 150 µm. The line width and the line spacing may be obviously decreased to below 10 µm, and the size of and the spacing between the vertical interconnect structures may be obviously decreased to below 150 µm. Therefore, the high interconnect precision of the 3D circuit layers and among the 3D circuit layers is achieved, that is, the multilayer PCB has higher interconnect precision.

At present, connection may be achieved by drilling the micro hole with a smaller diameter in the insulating layer through laser drilling and filling the metal slurry to get in touch with the circuits. However, when printing fine circuit scenes, as the line width, line thickness and other sizes of the circuit are smaller (only a few microns) than the size of the micro hole, the circuit at the bottom of the micro hole is easy to ablate by laser completely, resulting in absence of contact or little contact between the filled slurry and the metal circuits during filling, and conduction cannot be ensured. Therefore, in the present disclosure, the metal pillar is printed at the preset position of the 3D circuit layer to increase a connection area, to ensure interconnection of the circuits and avoid open circuit.

In order to meet the precision requirements of the line width, line spacing, and thickness of the insulating layer, in the present disclosure, the metal pillar is also printed by extruding the nanoscale metal slurry with shear thinning characteristics, to ensure the print size precision requirements of the metal pillar, and further ensure the interconnect precision of the high-precision multilayer PCB.

One preset metal pillar may only achieve interconnection between two adjacent three-dimensional circuit layers at most. In the present disclosure, the metal pillar located on the corresponding three-dimensional circuit layer right below the current three-dimensional circuit layer is led out of at least one insulating layer by drilling a hole in the insulating layer and filling the drilled hole with the slurry, and therefore interconnection between any two three-dimensional circuit layers can be achieved.

As the three-dimensional circuit layer is high in printing precision and small in size, coverage may be achieved only by coating a thinner insulating layer. While the vertical interconnect structure needs to penetrate through the insulating layer, and therefore on this basis, the size of the vertical interconnect structure may be reduced, to further ensure the interconnect precision of the high-precision multilayer PCB.

As it is unable to ensure that the upper surface of each substrate is a plane, the formation of the 3D circuit layer on the upper surface of the substrate in the present disclosure includes: measuring heights of all point positions on the upper surface of the substrate, to obtain a height data set of the upper surface of the substrate, and making the extrusion nozzle do relative motion in a Z-axis direction at the corresponding point position on the upper surface of the substrate according to the height data set of the upper surface of the substrate when the nanoscale metal slurry with shear thinning characteristics is extruded from the extrusion nozzle, so that the nanoscale metal slurry with shear thinning characteristics extruded from the extrusion nozzle forms the three-dimensional circuit layer on the upper surface of the substrate, to ensure uniform line type and line width.

The extrusion nozzle may shake during extrusion, resulting in deviation from an extrusion position, or the fixing position of the extrusion nozzle at the beginning has errors, which may also result in deviation from the extrusion position. The deviation from the extrusion position may seriously affect the position precision, line width and line type of the printed circuit under a high-precision printing scenario, resulting in uneven line type and line width, even line misalignment or printer head knock. Thus, in the present disclosure, when the three-dimensional circuit layer is formed on the upper surface of the substrate, the difference between an actual position and a preset position of the three-dimensional circuit layer at the specific point position on the upper surface of the substrate is measured, and the extrusion nozzle is corrected according to the difference. The correction includes correcting the stability of the extrusion nozzle and correcting a fixing position of the extrusion nozzle.

According to the present disclosure, the problems of delayed and uneven of the extrusion nozzle at the starting end of a formal extrusion forming route are solved by presetting curvilinear pre-extrusion motion before the formal extrusion forming route of the circuit. The problems of stacking and wire drawing from the extrusion nozzle at the tail end of the formal extrusion forming route of the circuit are solved by presetting an anti-spattering section at the tail end of the formal extrusion forming route of the circuit and cutting off a supply of extrusion power for extruding the nanoscale metal slurry with shear thinning characteristics.

In order to adapt to a high-precision printing scenario in this present disclosure, the surface morphology and thickness uniformity of the insulating layer need to meet extremely high quality requirements. In the present disclosure, the inclinations of the right end and left end of the coating tool bit are corrected before coating of the insulating layer.

In order to ensure the coating thickness of the insulating layer, in the present disclosure, the coating clearance between the coating tool bit and the coating surface is corrected before coating of the insulating layer.

The curing method provided by the present disclosure can ensure the preparation efficiency and precision of the high-precision multilayer PCB during preparation of the high-precision multilayer PCB with high interconnect precision by the extrusion-based 3D printing method. The problems of thermal effect of the curing process on precision equipment and repeated severe thermal deformation among the insulating layers, the metal pillars and the three-dimensional circuit layers in the curing process are solved.

The nanoscale metal slurry with shear thinning characteristics used in the present disclosure has adhesion, shape retention, electrical conductivity and extrusion continuity, reduces the wire drawing phenomenon at extrusion, and especially ensures the shape retention and adhesion of the metal pillar and the circuit in repeated curing processes during preparation of the high-precision multilayer PCB with high interconnect precision by the extrusion-based three-dimensional printing method. Therefore, the rate of the finished products of the high-precision multilayer PCB with high interconnect precision is improved.

The manufacturing method of the metal pillar provided by the present disclosure can improve the shape retention of the metal pillar and guarantee the printing size of the metal pillar during preparation of the high-precision multilayer PCB with high interconnect precision by the extrusion-based 3D printing method, so as to ensure smaller overall size of the vertical interconnect structure and meet the high-precision interconnect requirements of the high-precision multilayer PCB.

### BRIEF DESCRIPTION OF THE DRAWINGS

### DESCRIPTION OF THE DRAWINGS

In order to more clearly explain the embodiments of the present disclosure or the technical solutions of the prior art, the drawings needed in the description of the embodiments or the prior art will be briefly described below. Obviously, the drawings in the following description are only some embodiments of the present disclosure. For those ordinarily skilled in the art, other drawings can be obtained in accordance with these drawings without involving any inventive effort.
FIG. 1 is a flow chart of a 3D printing preparation method of a high-precision multilayer PCB according to the present disclosure;
FIG. 2 is a schematic diagram of a preparation process of a multilayer PCB;
FIG. 3 is a flow chart of a curing method in a preparation process of a high-precision multilayer PCB according to the present disclosure;
FIG. 4 is a flow chart of a manufacturing method of a metal pillar in a high-precision multilayer PCB according to the present disclosure;
FIG. 5 is a schematic diagram of a first vertical interconnect structure according to the present disclosure;
FIG. 6 is a schematic diagram of a first vertical interconnect structure unit according to the present disclosure;
FIG. 7 is a schematic diagram of a second vertical interconnect structure according to the present disclosure;
FIG. 8 is a schematic diagram of a second vertical interconnect structure unit according to the present disclosure;
FIG. 9 is a structural schematic diagram of interconnection between two adjacent three-dimensional circuit layers;
FIG. 10 is a structural schematic diagram of interconnection between three-dimensional circuit layers spaced by multiple layers;
FIG. 11 is a structural schematic diagram of interconnection between a bottom three-dimensional circuit layer and a top three-dimensional circuit layer;
FIG. 12 is a structural schematic diagram of interconnection among multiple three-dimensional circuit layers on a perpendicular line where the same metal pillar is located; and
FIG. 13 is a diagram showing an overall effect of a high-precision multilayer PCB.

In the figure: 1. Substrate; 2. three-dimensional circuit layer; 3. Insulating layer; 4. Metal pillar; 5. Extension part; 6. Lead wire; 7. Micro hole; and 8. Vertical interconnect structure.

### EMBODIMENTS OF THE PRESENT DISCLOSURE

### DETAILED DESCRIPTION OF THE PRESENT DISCLOSURE

The implementation of the present disclosure will be explained by specific embodiments. A person skilled in the art could easily conceive of other advantages and effects of the present disclosure from the disclosure of the specification. The present disclosure may be further implemented or applied in other different specific implementations, and various modifications or changes may also be made to the details in the specification based on different points of view and applications, without departing from the spirit of the present disclosure. It should be noted that the following embodiments and features in the embodiments may be mutually combined without conflicts.

### Embodiment 1:

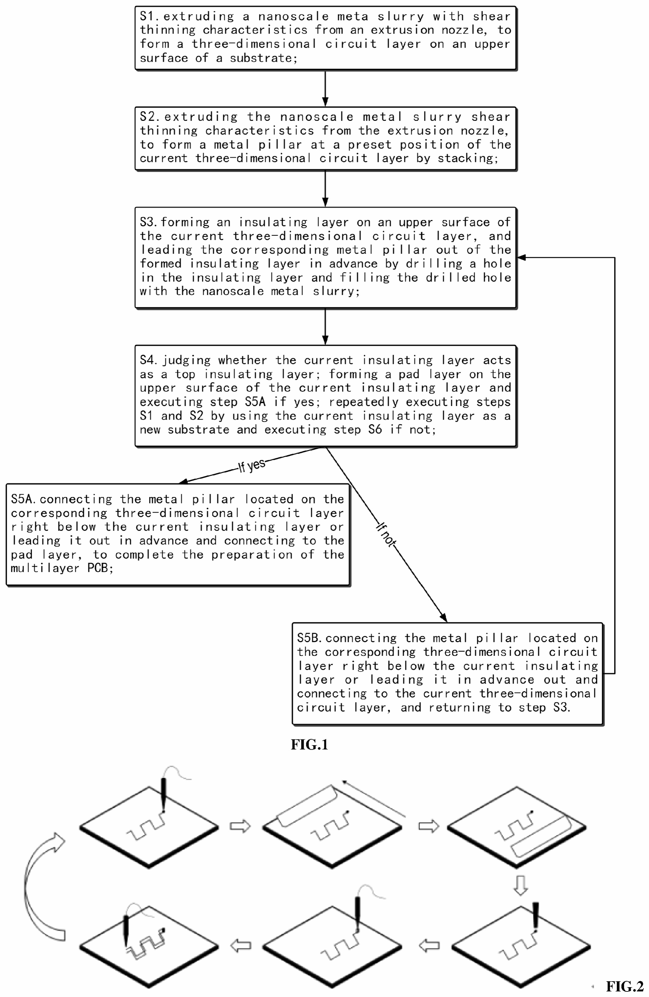

Referring to FIG. 1 and FIG. 2, this embodiment provides a 3D printing preparation method of a high-precision multilayer PCB, including the steps that
S1. a nanoscale metal slurry with shear thinning characteristics is extruded from an extrusion nozzle, to form a three-dimensional circuit layer on an upper surface of a substrate;
S2. a nanoscale metal slurry with shear thinning characteristics is extruded from the extrusion nozzle, to form a metal pillar at a preset position of the current three-dimensional circuit layer by stacking;
S3. an insulating layer is formed on an upper surface of the current three-dimensional circuit layer, and the corresponding metal pillar is led out of the formed insulating layer in advance by drilling a hole in the insulating layer and filling the drilled hole with the nanoscale metal slurry (specifically, the corresponding metal pillar is led out of the formed insulating layer in advance by drilling the hole in the insulating layer and filling the drilled holes with the nanoscale metal slurry according to the connection requirements of the three-dimensional circuit layers and the heights of the metal pillars on the three-dimensional circuit layers);
S4. it is judged whether the current insulating layer acts as a top insulating layer; if yes, a pad layer is formed on an upper surface of the current insulating layer and step S5A is executed; if not, steps S1 and S2 are executed repeatedly by using the current insulating layer as a new substrate and step S5B is executed;
S5A. the metal pillar located on the corresponding three-dimensional circuit layer right below the current insulating layer is connected or led out in advance and connected to the pad layer, to complete the preparation of the multilayer PCB; and
S5B. the metal pillar located on the corresponding 3D circuit layer right below the current three-dimensional circuit layer is connected or led out in advance and connected to the current three-dimensional circuit layer, and step S3 is executed again.

In this embodiment, a supercharging structure is driven through precision pressure control, and therefore the high-viscosity nanoscale metal slurry can be extruded from the extrusion nozzle (having an inner diameter of no less than 1 µm and made of glass or ceramic materials) at the tip of a precision printer head in a stringy shape.

### It can be known that

According to the present disclosure, the high-precision multilayer PCB with high interconnect precision is fabricated by an extrusion-based 3D printing method inventively, thereby improving the interconnection precision of the multilayer PCB.

The nanoscale metal slurry with shear thinning characteristics is extruded from the extrusion nozzle to form the 3D circuit layer on the upper surface of the substrate. The nanoscale metal slurry has shear thinning characteristics, and thus, the three-dimensional circuit layer is high in printing precision. A line width in the three-dimensional circuit layer may range from 1 µm to 150 µm, line spacing may range from 1 µm to 150 µm, a size of the vertical interconnect structure may range from 20 µm to 150 µm, and spacing therebetween may range from 20 µm to 150 µm. The line width and line spacing may be obviously decreased to below 10 µm, and the size of and the spacing between the vertical interconnect structures may be obviously decreased to below 150 µm. Therefore, the interconnection precision among the 3D circuit layers is high, that is, the multilayer PCB has a high interconnection precision.

At present, the connection may be achieved by drilling the micro hole with a smaller diameter in the insulating layer through laser drilling and filling the metal slurry to contact with the circuit. However, when printing fine circuit scenes, as the line width, line thickness and other sizes of the circuit are smaller (only a few microns) than the size of the micro hole, the circuit at the bottom of the micro hole is easy to ablate by laser completely, resulting in absence of contact or little contact between the filled slurry and the metal circuits during filling, and conduction cannot be ensured. Therefore, in the present disclosure, the metal pillar is printed at the preset position of the three-dimensional circuit layer to increase a connection area, to ensure interconnection of the circuits and avoid open circuit.

In order to meet the precision requirements of the line width, line spacing, and thickness of the insulating layer, in the present disclosure, the metal pillar is also printed by extruding the nanoscale metal slurry with shear thinning characteristics, to ensure the precision requirements of the print size of the metal pillar and further ensure the interconnection precision of the high-precision multilayer PCB.

One preset metal pillar may only achieve interconnection between two adjacent three-dimensional circuit layers at most. In the present disclosure, the metal pillar located on the corresponding three-dimensional circuit layer right below the current three-dimensional circuit layer is led out of at least one insulating layer by drilling a hole in the insulating layer and filling the drilled hole with the slurry, and therefore interconnection between any two three-dimensional circuit layers can be achieved.

As the three-dimensional circuit layer is high in printing precision and small in size, coverage may be achieved only by coating a thinner insulating layer. While the vertical interconnect structure needs to penetrate through the insulating layer, and therefore on this basis, the size of the vertical interconnect structure may be reduced, to further ensure the interconnection precision of the high-precision multilayer PCB.

### Specifically:

As each formed three-dimensional circuit layer, the corresponding metal pillar on the three-dimensional circuit layer or the coated insulating layer needs to be cured when the high-precision multilayer PCB is fabricated, the shape retention of the circuit on the three-dimensional circuit layer and the corresponding metal pillar on the three-dimensional circuit layer should be improved. However, the adhesion of the circuit will be reduced while the shape retention of the circuit is improved. Hence, the used nanoscale metal slurry with shear thinning characteristics should have shape retention and adhesion. Furthermore, as the fabricated PCB is the high-precision multilayer PCB, the stringing phenomenon occurred in the formation process of each three-dimensional circuit layer will affect the precision of the whole multilayer PCB. Thus, the used nanoscale metal slurry with shear thinning characteristics also should have a wire drawing effect. Furthermore, the used nanoscale metal slurry with shear thinning characteristics also needs to ensure electrical conductivity, to guarantee the normal use of the multilayer PCB. Furthermore, the used nanoscale metal slurry with shear thinning characteristics also needs to ensure continuity during extrusion, to avoid blockage of the extrusion nozzle or discontinuation of the slurry, thereby improving the rate of finished products when the high-precision multilayer PCB with high interconnection precision is fabricated by the extrusion-based 3D printing method.

The above nanoscale metal slurry with shear thinning characteristics may be selected from nanoscale silver slurry or nanoscale copper slurry.

Wherein, the nanoscale silver slurry with shear thinning characteristics may be prepared by the following steps that:
1. 2 g of short chain polyacrylic acid (PAA) solution (50 wt%, and 5000 g/mol), 1 g of long chain polyacrylic acid (PAA) solution (25 wt%, and 50000 g/mol) and 40 g of diethanolamine (DEA) are taken and dissolved in 50 ml of deionized water;
2. The obtained mixture is stirred at room temperature for 2 h to obtain a solution with a pH value of 9.5 as the first solution;
3. A silver nitrate solution (prepared by dissolving 20 g of silver nitrate in 20 ml of deionized water) is dropwise added to the first solution, and the obtained mixture is quickly stirred to obtain a second dark yellow solution;
4. The second solution is stirred at room temperature for 24 h, and gradually changes to dark black, to form silver nanoparticles with a diameter of 2-8 nm;
5. The obtained silver nanoparticles are stirred in a hot bath at 60°C for 2 h to obtain a third solution, and the size of the silver nanoparticles is changed to 5-50 nm by curing in this step;
6. 240 ml of ethyl alcohol is added to the third solution at 10 m1/min, and the obtained mixture is stirred for 20 min to obtain a fourth solution;
7. A supernatant is removed from the fourth solution IV, and precipitates are configured at 9000 rpm for 20 min, to obtain a dried nano silver slurry with high concentration; and
8. 10 wt% of solvents (prepared by mixing 30 wt% of ethylene glycol and 70 wt% of water, and used for dissolving the polyacrylic acid and the diethanolamine and moisturizing) are added to the dried nano silver slurry for shaking uniformly, and then the obtained mixture is deformed in a vacuum chamber at 50°C and 25 mbar for 30 min, to obtain the nanoscale silver slurry with shear thinning characteristics.

Wherein, the nanoscale copper slurry with shear thinning characteristics may be prepared by the following steps that:

8 g of bisphenol A-type epoxy resin is weighed and dissolved in 15 g of butyl acetate solvent, and the obtained mixture is heated to 80°C to hold for 1 hour, till the mixture is completely dissolved to obtain a primary carrier. 1 g of anhydride curing agent is weighed and added to the primary carrier, and the obtained mixture is dispersed by a high-speed disperser at high speed, heated to 30°C-35°C after being dispersed uniformly, and aged for 2 hours to obtain a dispersion medium. 70 g of 100-200 nm copper powder, 5 g of reductant triphenylphosphine, 0.2 g of nano graphene powder as a non-conducting filler and 0.8 g of 50 nm silicon dioxide powder are weighed and mixed with the dispersion medium in a mixer fully, and the obtained mixture is dispersed by the high-speed disperser at high speed to obtain a uniform primary slurry. The primary slurry is rolled by a three-roll mill for 6 times till a fineness is less than 1 µm, and then the obtained slurry is filtered by a 10 µm filter screen to obtain the nanoscale copper slurry finally. For a specific preparation method of the nanoscale copper slurry, refer to the Chinese patent with a publication number of CN113362984A.

Based on the above description, those skilled in the art may change concentrations and other parameters to obtain the nanoscale metal slurry with shear thinning characteristics and performance that meets the requirements in the present disclosure.

Generally, in step S1, the nanoscale metal slurry with shear thinning characteristics is an organic dispersion system containing metal nanoparticles, including the metal nanoparticles and the dispersion medium. The content of the metal nanoparticles ranges from 75% to 95%, and the viscosity of the slurry ranges from 100,000 cps to 1,000,000 cps. A thixotropic index ranges from 4 to 10, and a height-width ratio of the formed line is no less than 0.4. The metal solid content is high, which may improve the shape retention, reduce wire drawing of the printer head and shrinkage during sintering, and increase electrical conductivity. However, the adhesion to glass, silicon wafers and polyimide substrates will be reduced. If the metal solid content is too low, the electrical conductivity will be reduced, and the shrinkage during slurry sintering is too large, which easily results in open circuit. Due to high surface energy, the metal nanoparticles are prone to aggregate and combine into large particles to block the extrusion nozzle, and hence the corresponding dispersion medium should be added to the slurry for dispersing the nanoparticles and avoiding aggregation. For the metal nanoparticles of different materials, the suitable dispersion medium should be selected and other auxiliary materials are added according to the physicochemical properties of the metal nanoparticles.

For the nanoscale silver slurry, the dispersion medium includes a dispersion solvent and a binder. The dispersion solvent includes any one or more of an organic solvent and water, and the binder includes any one or more of a polyacrylic acid, a diethanolamine and a complex of the polyacrylic acid and the diethanolamine. The polyacrylic acid includes a short chain polyacrylic acid and a long chain polyacrylic acid, and the organic solvent includes any one or more of ethylene glycol and glycerin. As the silver nanoparticles have excellent oxidation resistance and the dispersion medium contains the polyacrylic acid and diethanolamine components (the polyacrylic acid has excellent adhesion to the substrate and is capable of dispersing metal particles, and the diethanolamine reduces metal ions into metal particles slowly), additional protective agents and curing agents may not be added. A mass ratio of the short chain polyacrylic acid to the long chain polyacrylic acid ranges from 2: 1 to 8:1, a molar mass of the short chain polyacrylic acid ranges from 1,000 g/mol to 10,000 g/mol, and the molar mass of the long chain polyacrylic acid ranges from 10,000 g/mol to 100,000 g/mol. The printing effect, adhesion to the substrate, and electrical conductivity of the slurry after sintering for curing may be regulated by adjusting the mass ratio and polymerization degree of the polyacrylic acid with different molecular weights, as well as the content and moisture content of the silver nanoparticles.

For the nanoscale copper slurry, the dispersion medium includes a dispersion solvent and a binder. The dispersion solvent includes any one or more of an organic solvent and water, and the binder includes an epoxy resin, a curing agent and a protective agent. The epoxy resin is a thermosetting epoxy resin, and the thermosetting epoxy resin includes any one or more of a bisphenol A-type epoxy resin, an E-44 epoxy resin and a biphenoxy epoxy resin. The curing agent is any one of a polythiol curing agent, a dicyandiamide curing agent and an anhydride curing agent. The organic solvent includes any one or more of diethylene glycol monoethyl ether acetate, dibasic ester, isophoron, terpineol and diethylene glycol monobutyl ether. The nanoscale metal slurry with shear thinning characteristics further includes a protective agent, and the protective agent is formed by any one or a combination of more of a triarylphosphine compound and a trialkylphosphine compound. The nanoscale metal slurry with shear thinning characteristics further includes a non-conducting filler, and the non-conducting filler is formed by any one or a combination of more of carbon powder, nano graphene powder, bentonite and nano silica powder. The copper nanoparticles are easy to oxidize by moisture and air, and the dispersion medium contains the epoxy resin component (the epoxy resin is hydrophobic and capable of inhibiting water intrusion, and has excellent adhesion to the substrate after curing). Hence, the protective agent is added to inhibit oxidation of the copper nanoparticles, and the curing agent is added to make the epoxy resin quickly cured after being heated. The non-conducting filler may be added according to actual viscosity and thixotropy requirements.

The nanoparticles of the nanoscale metal slurry with shear thinning characteristics have excellent dispersibility, and may be smoothly extruded from a capillary glass tube with an inner diameter ranging from 1 µm to 150 µm. The volume shrinkage of the slurry after curing is less than 30%, and the slurry has excellent adhesion to glass, silicon wafers and polyimide substrates (a thickness of slurry of about 20 µm thick is coated on the glass substrate by a scraper and cured by sintering at 200°C; then, the obtained coating is stripped with a 3M Scotch 600 adhesive tape, and there is no stripping phenomenon). The viscosity and thixotropic index of the slurry are characterized by a conventional Brookfield rotational viscometer. The water absorption of the slurry is no more than 5% at a relative humidity ranging from 20% to 60% and 23°C±5°C (the shape retention and shrinkage effect after sintering are affected; a test method is as follows: a thickness of slurry of about 100 µm thick is coated on the glass substrate by the scraper, and the glass substrate is weighed by a precision electronic scale; and a mass increment is no more than 5% after an interval of 1 h).

A height-width ratio of a line formed by existing slurry for fabricating a single-layer high-precision PCB is generally 0.2 or so. As the multi-layers need to be vertically interconnected with each other in the present disclosure, a small height-width ratio of the line formed by the slurry will be unable to support a key process such as metal pillar printing in the present disclosure. Meanwhile, application scenarios of the multilayer PCB are more complex (such as high voltage signal, high current and the like) than those of the single-layer PCB, and the circuit thickness requirement of the multilayer PCB is higher than that of the single-layer PCB. Therefore, if the multilayer PCB is fabricated by using the slurry with a small height-width ratio of the line, the thickness of the circuit needs to be improved at the expense of the precision of the line width and line spacing. As a result, the high-precision multilayer PCB with high interconnect precision cannot be prepared.

A plurality of insulating layers should be coated during preparation of the multilayer PCB to form a plurality of substrates for printing the three-dimensional circuit layers, and hence high-precision coating is required, to ensure that the thicknesses of the formed substrates are kept consistent and that the upper surface of each substrate is a plane. However, slight deviations in coating clearance and coating inclination in the coating process easily result in errors, and every insulating layer needs to be cured after completion of coating. Even though the precisions of the insulating layers are consistent during coating, it is also difficult to ensure that the formed substrates are consistent in precision after curing, and it cannot ensure that the upper surface of each substrate is a plane. The extrusion nozzle needs to approach to the printing substrate during printing, to make stringy slurry come in contact with the printed substrate. The rugged and rough surface of the printing substrate may seriously affect the state of the printed circuit in high-precision printing scenarios, resulting in uneven line type and line width, even open circuit or printer head knock.

Therefore, in view of the above situation that the upper surfaces of the substrates cannot be ensured to be a plane, in step S1, the formation of the three-dimensional circuit layers on the upper surface of the substrate includes: a height of each point position on the upper surface of the substrate is measured to obtain a height data set of the upper surface of the substrate; the extrusion nozzle does relative motion in a Z-axis direction at the corresponding point position on the upper surface of the substrate when the nanoscale metal slurry with shear thinning characteristics is extruded from the extrusion nozzle, and therefore the distances between the extrusion nozzle and the point positions on the upper surface of the substrate are kept consistent when the nanoscale metal slurry with shear thinning characteristics is extruded from the extrusion nozzle, that is, the printing of the three-dimensional circuit layer is three-dimensional printing. In the printing process, the extrusion nozzle does relative motion in a Z direction relative to the point positions on the upper surface of the substrate, and therefore the three-dimensional circuit layer is formed on the upper surface of the substrate finally, to ensure uniform line type and line width.

Detailedly, in this embodiment, the heights of the point positions on the upper surface of the substrate are measured by a laser displacement sensor, to obtain a height data set of the upper surface of the substrate. A resolution of the laser displacement sensor should be no more than 0.3 µm. If the resolution is out of limits, a compensation precision cannot be ensured in large-format scenarios, resulting in inaccurate control over the height between the extrusion nozzle and the substrate during printing. Through the Z-direction motion of the substrate, the extrusion nozzle does relative motion in the Z-axis direction at the corresponding point position on the upper surface of the substrate during printing.

Similarly, the printer head needs to approach to the substrate during extrusion of the slurry in the present disclosure, and therefore the stringy slurry is in contact with the substrate. Shaking caused by pneumatic propulsion may seriously affect the position precision of the printed circuit as well as the line width and line type in high-precision printing scenarios, resulting in uneven line type and line width, even circuit misalignment or printer head knock. Therefore, a metal securing mechanism needs to be additionally installed on a base of the printer head. Meanwhile, when the three-dimensional circuit layer is formed on the upper surface of the substrate, the difference between an actual position and a preset position of the three-dimensional circuit layer at the specific point position on the upper surface of the substrate is measured, and the stability of the printer head is corrected according to the difference. Horizontal and vertical shaking deviations of the printer head after securing are controlled within 0.5 µm, to prevent the difference between the actual position and the preset position from exceeding a preset threshold.

It should be noted that the excessive difference between the actual position and the preset position may be caused by deviation from the fixing position of the printer head other than the shaking of the printer head in some cases. In this embodiment, pre-designed circuit patterns are imported into a computer numerical control (CNC) route by a computer aided manufacturing (CAM) technology. The printer head moves along the CNC route to form required circuit patterns. In the case of deviation from the fixing position of the printer head, the whole circuit pattern will deviate. At this point, the fixing position of the printer head may be corrected according to the difference between the actual position and the preset position.

It should be noted that, if the deviation is caused by shaking influence, the deviation may change when the pneumatic propulsion for printing is On and Off. If the deviation is caused by influence of the fixing position, the deviation will not be affected when the pneumatic propulsion for printing is On and Off.

Furthermore, in the present disclosure, the extrusion-based 3D printing method is adopted. During extrusion of the slurry in the extrusion-based 3D printing method, problems of delayed and uneven extrusion may occur at a starting end of a line, and problems of stacking and wire drawing may occur at a tail end of the line, which seriously affect the printing precision of the line. During preparation of the multilayer PCB, such an effect is obvious after layer-by-layer accumulation.

In order to solve the problems of delayed and uneven extrusion at the starting end of the line, the present disclosure provides the following technical solution: the extrusion nozzle does curvilinear pre-extrusion motion on a plane perpendicular to the substrate before the nanoscale metal slurry with shear thinning characteristics is extruded from the extrusion nozzle to form a starting end of each line in the 3D circuit layer, and the extrusion nozzle moves along a formal extrusion forming route of the circuit in a tangent direction of the curve, that is, the curve acts as a preparatory extrusion section to avoid the problems of delayed and uneven extrusion during formal extrusion.

In order to solve the problems of stacking and wire drawing at the tail end of the line, the present disclosure provides the following technical solution: a preset anti-spattering section is disposed at the tail end of the formal extrusion forming route of the circuit. The action of extruding the nanoscale metal slurry with shear thinning characteristics is cut off when the extrusion nozzle is located at the anti-spattering section. Namely, an extrusion power supply for extruding the nanoscale metal slurry with shear thinning characteristics is cut off when the extrusion nozzle is located at the anti-spattering section. The anti-spattering section accounts for 5% to 30% of a total length of a final section of each circuit (note: one circuit includes a plurality of sections of printing paths in continuous printing, and the final section of the circuit refers to a final section of printing path in the circuit).

The above circuit may retain its pattern shape and section shape after completion of printing, and has a line type with a specific height-width ratio (the ambient relative humidity should be controlled at 20% to 60% during printing of the circuit; the slurry is not prone to adhere to the substrate if the ambient relative humidity is too low, and the slurry is prone to absorb moisture, resulting in a decrease in shape retention, if the ambient relative humidity is too high).

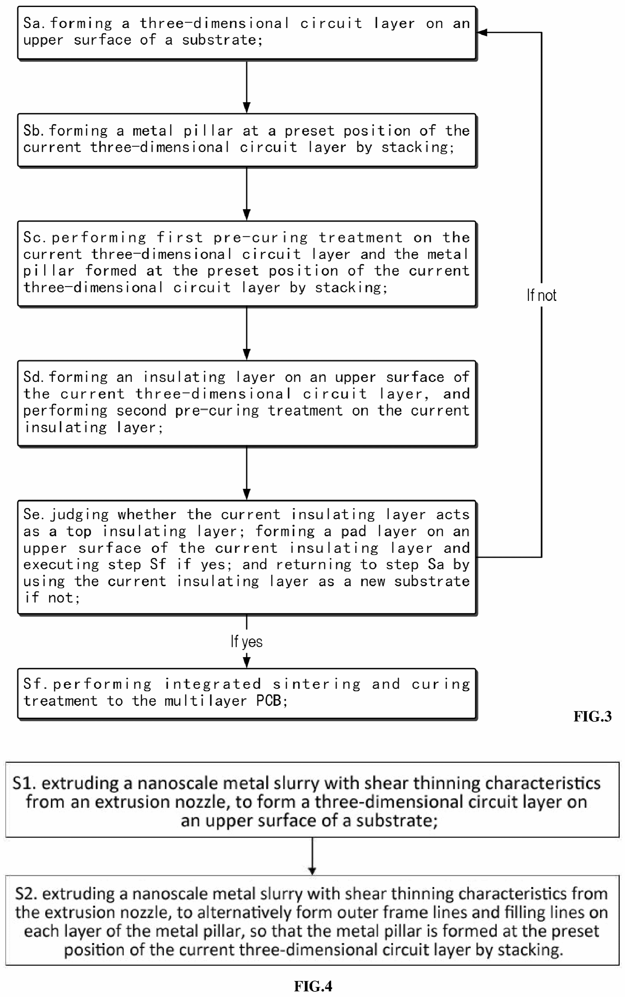

Furthermore, the multilayer PCB consists of three-dimensional circuit layers and insulating layers which are alternatively stacked on each other, and therefore the three-dimensional circuit layers and the insulating layers need to be cured after formation for the next three-dimensional circuit layer or insulating layer to be formed thereon. The present disclosure aims at the preparation of the high-precision multilayer PCB, and the preparation precision may be up to less than 10 µm. If high-temperature complete curing is adopted for each three-dimensional circuit layer or insulating layer, repeated severe thermal deformation may occur between an insulating medium and the circuit. Thermal stress between the circuit and the medium as well as inherent thermal stress of the circuit and the medium will result in open circuit and failure in the process. In addition to this, repeated high-temperature heating may also aggravate the expansion and shrinkage problem of the insulating medium, resulting in oxidization of the insulating medium. Therefore, in the present disclosure, a method of pre-curing + integrated sintering for curing - which is not part of the claimed invention - is adopted, as shown in FIG.3, and includes the following steps that:
Sa. A three-dimensional circuit layer is formed on an upper surface of a substrate;
Sb. A metal pillar is formed at a preset position of the current three-dimensional circuit layer by stacking;
Sc. First pre-curing treatment is conducted on the current three-dimensional circuit layer and the metal pillar formed at the preset position of the current three-dimensional circuit layer by stacking;
Sd. An insulating layer is formed on an upper surface of the current three-dimensional circuit layer, and second pre-curing treatment is conducted on the current insulating layer;
Se. It is judged whether the current insulating layer acts as a top insulating layer; if yes, a pad layer is formed on an upper surface of the current insulating layer and step Sf is executed; if not, step Sa is executed again by using the current insulating layer as a new substrate; and
Sf. The integrated multilayer PCB is cured by sintering.

### Specifically:

For the three-dimensional circuit layer formed on the upper surface of the substrate and the metal pillar formed at the preset position of the current three-dimensional circuit layer by stacking, a curing temperature for first pre-curing treatment in the present disclosure ranges from 100°C to 150°C, and curing time ranges from 3 min to 10 min. The circuit is shaped while moisture is removed from circuit materials, and the circuit adhesion to the substrate is improved for coating operation of the next insulating layer.

After curing of the three-dimensional circuit layer and the metal pillar, the insulating layer coated on the three-dimensional circuit layer is also cured by a pre-curing treatment method. Specifically, the insulating layer containing solvents is pre-cured firstly after coating, and the solvents (especially water, ethyl alcohol, dimethylacetamide and other strong polar solvents) in a wet film volatilize, to avoid film variation (liquid flow, uneven shrinkage and the like), dissolution of the circuit by residual solvents or decrease in the circuit adhesion to the substrate. Furthermore, in order to avoid problems of bubbles, wrinkles and the like, stepwise pre-curing treatment is conducted on the insulating layer at Level 2 or above. Here, taking 2-level stepwise pre-curing treatment as an example, curing is conducted at 60°C to 95°C for 3 min to 10 min, and then cured at 120°C to 200°C for 3 min to 10 min. The coating materials of the insulating layer usually contains a large amount of solvents. If the insulating layer is cured at a higher temperature directly, the solvents volatilize violently, and as a result skin effects are easily caused (the coating surface is quickly heated, dried and hardened). The resulting bubbles and residual solvents cannot be discharged in time to form residual bubbles and uneven wrinkles, and meanwhile strong thermal stress is formed in the film due to too fast heating, and may result in deformation of the circuit.

The method further includes the steps between step Sd and step Se: the corresponding metal pillar is led out of the formed insulating layer in advance by drilling a hole in the insulating layer and filling the drilled hole with the nanoscale metal slurry, and third pre-curing treatment is conducted on the filled nanoscale metal slurry. The third pre-curing treatment described here is similar to the first pre-curing treatment, and will not be explained detailedly.

After formation of the 3D circuit layers, insulating layers and pad layers (which are connection layers for connecting the prepared multilayer PCB with external electronic components, and see the description of the metal pillar hereinbelow for its detailed explanation), the layers need to be cured overall by sintering (it should be noted that after formation of the pad layer on a top layer of the multilayer PCB, the pad layer does not need to be pre-cured, but directly cured overall by sintering). Specifically, if the insulating layer is made from an organic medium and thermally cured in an air atmosphere, integrated sintering and curing treatment is conducted by a muffle sintering method; and a sintering temperature ranges from 200°C to 300°C, and sintering time ranges from 1 h to 3 h. The sintering conditions may vary depending on different kinds of nanoscale metal slurry, for example, as copper is easy to oxidize, generally, integrated sintering curing of the nanoscale copper slurry needs to be conducted in a nitrogen atmosphere (see the description of Embodiment V hereinafter for details). If infrared, laser or photonic sintering methods are used, the sintering time of the nanoscale metal slurry may be further reduced; due to limited temperature resistance of conventional organic substrates, such as an FR-4 epoxy glass fiberboard, and organic insulating materials, such as bismaleimide triazine (BT), polyimide (PI), epoxy resin and benzocyclobutene (BCB), the integrated sintering for curing is generally conducted at 200°C to 300°C in the present disclosure. If the insulating layer is made from low temperature co-fired ceramic (LTCC), such as aluminum oxide-based LTCC and aluminum nitride-based LTCC, the integrated sintering treatment for curing is conducted by a low temperature ceramic co-firing method, a sintering temperature is 850°C, and sintering time ranges from 0.5 h to 2 h. Through integrated sintering for curing, organic matter is removed partially or completely from the slurry. Metal particles are bonded to each other, crystal grains grow up, and voids (pores) and grain boundaries are gradually decreasing in trend. A metal circuit with high electrical conductivity and specific uniform line type is formed finally; and through integrated sintering for curing, the insulating medium forms a stable insulating layer with specific electrical properties.

Wherein, pre-curing is mainly featured by low temperature and short time in terms of curing parameters compared with integrated sintering for curing. The pre-curing plays a role in shaping the medium in time, ensuring that the circuit meets requirements of subsequent processes, enhancing the circuit adhesion to the medium, improving the efficiency and reducing the thermal effect on precision equipment.

It should be specially noted that curing conditions of the metal slurry are incompatible with those of the insulating medium. The insulating layer is made from the organic medium and needs to be fully and thermally cured in a special atmosphere (for example, polyimide of a high temperature curing type in nitrogen atmosphere generally needs to be fully cured at 350°C; direct high-temperature curing of the polyimide in air atmosphere may result in oxidation, and consequently the cured polyimide blackens and the mechanical strength thereof is reduced), while the silver slurry prepared by the formula stated in this embodiment needs to be cured in air atmosphere. For the situation that the curing conditions of the metal slurry are incompatible with those of the insulating medium, a hybrid sintering and curing method is preferably adopted, that is, each layer of metal circuit and metal pillar are subjected to selective direct complete curing by laser, and the overall multilayer PCB is fully cured at high temperature in an off-line special atmosphere furnace. The laser used here is different from ultraviolet picosecond laser used in laser drilling as mentioned hereinafter, and may be minitype continuous or millisecond pulsed laser at an infrared band. When the metal slurry is cured by laser, it should be noted that laser radiation easily leads to violent evaporation and decomposition of organic components in the nanoscale metal slurry as the laser is locally input high energy. When the metal pillar and the surface pad layer are cured by laser, excessive energy input within a short time may result in obvious bubbling. The metal pillar and the surface pad layer also need to be cured with a stepwise curing method by laser, generally, firstly pre-cured under laser power of 5 W to 15 W, and then completely cured under high power of 20 W to 50 W.

### More specifically:

In this embodiment, for coating of the above insulating layer, the coating tool bit should be made of metal materials, and the planeness of a plane at a tool edge is no more than 2 µm. The coating process includes correcting the inclination of the coating tool bit and the coating clearance.

Correction of inclination of the coating tool bit: it can be known from the above description that the surface of the insulating layer acts as a substrate surface for circuit printing, so the surface morphology and thickness uniformity of the insulating layer should meet extremely high-quality requirements to adapt to a high-precision printing scenario in this embodiment. The inclinations of the right end and left end of the coating tool bit need to be corrected before coating operation. Specifically, a Z-axis motor is controlled to make the coating tool bit descend so that the right end and left end thereof get in touch with a high-precision contact sensor respectively. When the contact sensor receives touch pressure from the coating tool bit, contact signals are triggered after the touch pressure reaches a threshold value of the sensor. A height of the Z-axis motor is recorded when the right end and left end of the coating tool bit trigger the contact sensor to emit signals, and then feedback is made to obtain the side-to-side inclination of the coating tool head. Precision screw ejector rods on right and left sides above the coating tool bit are regulated according to the inclination information to control the side-to-side inclination, and measurement and regulation are performed repeatedly, till the height difference between the right end and the left end is no more than 2 µm (it should be noted that the overall side-to-side inclination of the controlled tool bit and the planeness (≤2 µm) of the plane at the tool edge are not the same concept, and the planeness of the plane at the tool edge refers to a maximum fluctuation difference of the plane at the tool edge).

Correction of the coating clearance: a height clearance between the coating tool bit and the substrate surface is an important coating parameter, and has significant influence on the thickness of the insulating layer. There is no mechanical connection structure between the coating tool head and the substrate in this embodiment, and the height clearance there between needs to be corrected by means of a laser displacement sensor and a high-precision contact sensor. Firstly, a height of a contact surface of the contact sensor is detected by the laser displacement sensor before coating, to obtain the height of the contact sensor; then, a height of a starting point of coating on the coating surface is detected by the laser displacement sensor, to obtain the height of the starting point of the coating; next, a relative height difference between the contact sensor and the starting point of the coating is calculated according to the heights of the contact sensor and the starting point of the coating; a centre of the coating tool bit with inclination corrected gets in touch with the contact sensor, and the height of the coating tool bit in a Z axis at the time of touching is recorded; and finally, the height of the coating tool bit in the Z axis is corrected according to the relative height difference between the contact sensor and the starting point of the coating, the height of the coating tool bit in the Z axis at the time of touching the contact sensor, and a preset coating clearance.

### In this embodiment, for coating of the insulating layer:

A basic structure of the multilayer PCB consists of a plurality of insulating layers and three-dimensional circuit layers which are stacked on each other. The three-dimensional circuit layer consists of metal conductor patterns, and the insulating layer consists of organic resins or inorganic ceramic. In the present disclosure, the plurality of insulating layers are stacked by scraper coating or slit coating layer upon layer, and each insulating layer is in situ coated by the coating tool bit integrated with equipment. The coating tool bit is assembled on a Z shaft controlled by a servo motor. The coating tool bit descends to a position of a specific height above the substrate during coating, and keeps stationary. A sample stage for which the substrate is placed is controlled to move forwards, and therefore the coating tool bit moves relative to the substrate surface for coating. Precision control may be achieved by regulating a clearance between the coating tool bit and the substrate, a moving speed of the substrate, shrinkage of the insulating medium material and other parameters. The coating tool bit has two types of a scraper coating tool bit and a slit coating tool bit. When using the scraper coating tool bit, firstly, a certain amount of insulating medium material is applied to the substrate by extrusion, and then the coating tool bit moves relative to the substrate to push the insulating medium material to form a coating film on the substrate; when using the slit coating tool bit, as the tool bit has an extrusion slit, the slit coating tool bit moves relative to the substrate for extrusion to form a coating film on the substrate after regulation of a slit clearance, a slit extrusion amount and an extrusion speed. The above coating processes may be performed repeatedly to obtain a thicker insulating layer; especially for some insulating medium materials (such as polyimide liquid material) with high solvent content, when a thicker coating film (generally, the coating thickness is larger than 100 µm) is applied at a time, solvents required therefor volatilize too much, and shrinkage stress is obvious, which easily result in bubbles or breakage of a fine circuit. Repeated coating forming is preferred for such materials. A too thin coating may lead to surface undulation, and the undulating morphology of a former circuit layer may be reflected in a dielectric surface; (as the circuit has a certain height), the spacing between the printer head and the substrate surface undulates when the next circuit layer is printed right above the former circuit layer. As the former circuit layer is small in size, the undulation caused by the circuit only exists in a local area above the circuit, which may not be solved by moving the substrate in a Z-axis direction as described above. Therefore, when the insulating medium is coated, the thickness of the medium should be at least two times larger than that of the former circuit, to reduce height influence of the former circuit.

The following description is given to a vertical interconnect structure in the high-precision multilayer PCB.

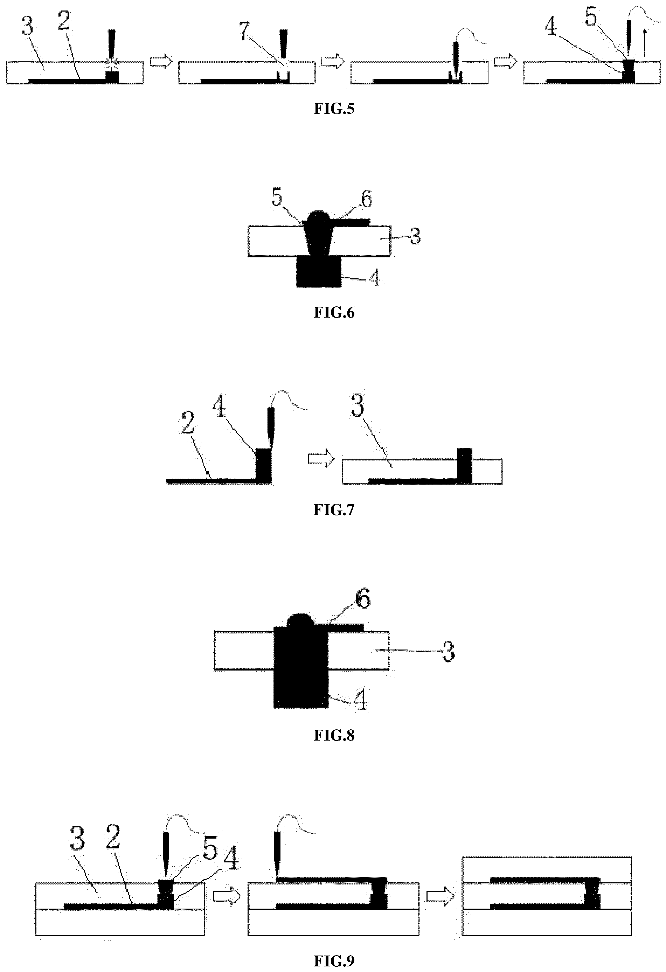

Referring to FIG.5 to FIG. 8, the present disclosure relates to two vertical interconnect structures. The first vertical interconnect structure consists of metal pillars 4, micro holes 7 and nanoscale metal slurry filled therein (it should be noted that the filled nanoscale metal slurry may be regarded as extension parts 5 of the metal pillars 4), lead wires 6 (the lead wires 6 are used for connecting the metal pillars 4 with three-dimensional circuit layers 2 or connecting the extension parts 5 with the three-dimensional circuit layers 2). The second vertical interconnect structure consists of metal pillars 4 and lead wires 6 directly. In the first vertical interconnect structure, process requirements for a height of the metal pillars 4 and a thickness of the insulating layers 3 are lower; the insulating layers 3 cover the metal pillars 4 completely, and the surface of the insulating layers 3 is relatively flat. However, a laser assisted process is required for forming and filling of the micro holes 7 in the insulating layers. In the second vertical interconnect structure, although aids are not required, the surfaces of the metal pillars 4 should be able to penetrate through the pre-cured insulating layers 3 (that is, the insulating layers 3 shrink after pre-curing, to allow the surfaces of the metal pillars 4 to penetrate through the insulating layer 3). As the surfaces of the insulating layers 3 have bent portions in a small area near the metal pillars due to surface tension, process control requirements for material state, height of the metal pillar, coating thickness and the like are higher.

Specifically, the metal pillar is an important component of the vertical interconnect structure in the present disclosure. Referring to FIG. 4, the metal pillar is printed at a circuit position where vertical interconnection is required by the high-precision 3D printing method in the present disclosure, and stacked layer upon layer. The metal pillar is generally cubic or cylindrical, and the printing method includes the steps:
S1. a nanoscale metal slurry with shear thinning characteristics is extruded from an extrusion nozzle, to form a three-dimensional circuit layer on an upper surface of a substrate; and
S2. a nanoscale metal slurry with shear thinning characteristics is extruded from the extrusion nozzle, to alternatively form outer frame lines and filling lines on each layer of the metal pillar, so that the metal pillar is formed at the preset position of the current three-dimensional circuit layer by stacking.

The nanoscale metal slurry with shear thinning characteristics includes metal nanoparticles and a dispersion medium. The content of the metal nanoparticles ranges from 75% to 95%. The viscosity of the nanoscale metal slurry with shear thinning characteristics ranges from 100,000 cps to 1,000,000 cps, and a thixotropic index ranges from 4 to 10. A height-width ratio of the line formed by the nanoscale metal slurry with shear thinning characteristics is no less than 0.5.

The nanoscale metal slurry with shear thinning characteristics prepared by the above steps in the specification of the present disclosure can meet the requirements of this step. While the nanoscale metal slurry with shear thinning characteristics for printing the metal pillar is preferably higher in shape retention, and the height-width ratio of the formed line is no less than 0.5. Moreover, the ambient humidity for printing the metal pillar is preferably controlled at 20% to 60%. If the shape retention capability of the slurry and the ambient relative humidity (20% to 60%) during printing fail to meet the requirements, the metal pillar may collapse or deform during printing, and consequently sizes are substandard. When the metal pillar is printed layer upon layer, each layer has an outer frame line and a filling line, and an overlapping ratio of the filling lines ranges from 5% to 15%. A deviation of a total extrusion volume (the printing time of the metal pillar * extrusion mass per unit time under given air pressure/slurry density) required for printing the metal pillar from a design volume of the metal pillar is smaller than 10%. Volume matching errors may lead to surface indentation or oversize after pre-curing of the metal pillar. A diameter of the metal pillar structure prepared in this embodiment generally ranges from 20 µm to 150 µm, a height ranges from 3 µm to 150 µm, and an upper surface of the metal pillar is a plane (the planeness is no more than 1 µm). It should be additionally noted here that the above pad layer may include a plurality of pads. A formation process of the pad is similar to that of the metal pillar, which is also printing layer upon layer, and each layer has an outer frame line and a filling line. The pad may also be conceived in this embodiment as a metal pillar of which the sizes in X and Y directions are much larger than the height in a Z direction for connection between the multilayer PCB and an external electronic component. The pad will not be described here detailedly). The height and cross section size of the metal pillar need to be determined according to the requirements of interconnect precision, thickness of the insulating layer and selection of the vertical interconnect structures. For the metal pillar of the first vertical interconnect structure, if the metal pillar is too short during printing, the metal pillar may be punched during subsequent laser drilling; if the metal pillar is too long, the upper insulating medium coating film may bulge, consequently the subsequent process of making the lead wire is unstable, and the printed lead wire is easy to break. For the second vertical interconnect structure, the printing height of the metal pillar should be high enough so that the upper surface of the metal pillar may be higher than the pre-cured insulating layer. The insulating layer material in this embodiment should contain certain solvents to ensure that the thickness after pre-curing has sufficient shrinkage. If the thickness of the pre-cured insulating layer has no shrinkage, the metal pillar will not be higher than the insulating layer.

Forming of the micro hole: a diameter of the micro hole ranges from 15 µm to 150 µm. The forming and filling of the micro hole are only for the first vertical interconnect structure. When the thickness of the coated insulating layer is larger, the metal pillar is covered with the insulating layer completely. The insulating layer right above the metal pillar is broken by a laser drilling method to form the micro hole. Laser drilling is conducted preferably by an ultraviolet picosecond laser device, a wave length is 343 nm or 355 nm, an average power ranges from 3 W to 10 W, a pulse width is less than 15 ps, and a repetition frequency ranges from 200 KHz to 1 MHZ. Ultraviolet picosecond processing belongs to cold processing, and has a better effect on micro hole forming in organic or ceramic insulating layers. The surface of the metal pillar right below the insulating layer may have ablating traces due to an ablation effect of the ultraviolet picosecond laser, and the surface may be in a dented state. The diameter of the micro hole formed by infrared femtosecond, green picosecond or ultraviolet nanosecond laser devices is larger, and the adaptability to the insulating layer material is poor. Such laser devices easily punch through the metal pillar, and are applicable for some specific insulating layers and processing of micro holes ranging from 80 µm to 150 µm. Laser emitting from the laser devices focuses on a sample surface through a polariscope and a telecentric lens to scan and drill line by line based on visual positioning, and a diameter of a focal spot ranges from 10 µm to 25 µm. A drilling path is a screw auger path. If the laser scanning deviation is larger, the insulating layer right above the metal pillar may not be ablated completely and the metal circuit near the metal pillar is damaged, which affects electrical conduction. In order to avoid the laser scanning deviation, a mark point needs to be identified by visual positioning during laser drilling. However, in some insulating layer scenarios where a thermal expansion coefficient is large, as expansion and shrinkage risks caused by layer-by-layer pre-curing of the insulating layers in the present disclosure are increased, when the expansion and shrinkage situation occur and mark identification effects are not good, it is necessary to use a metal pillar template for identification, that is, point positioning is achieved by visually grabbing an outer contour of the corresponding metal pillar, which is also one of the reasons why the metal pillar should have high shape retention.

Filling of the micro hole: the micro hole may be filled with a nanoscale metal slurry (it should be noted that the nanoscale metal slurry described here may have no shear thinning thixotropic effect) by a precision pneumatic extrusion method or filled with a nanoscale metal slurry (it should be noted that the nanoscale metal slurry described here is a low-viscosity slurry material applicable for inkjet and having no shear thinning thixotropic effect) by an inkjet method. The precision pneumatic extrusion method has sufficient high extrusion precision and is applicable for filling of the micro hole with a diameter ranging from 15 µm to 150 µm and hole spacing greater than 20 µm, and the inkjet method is only applicable for filling of the micro hole with a diameter ranging from 100 µm to 150 µm and hole spacing greater than 100 µm as the droplet size is large. As the metal pillar is at the bottom of the micro hole, the filled slurry may be in full contact with the surface of the metal pillar for wetting. If the metal pillar is too short and laser energy input is excessive, the metal pillar may be punched during forming of the micro hole, and consequently the filling slurry is filled into the lower three-dimensional circuit layer to result in an electrical short circuit. Furthermore, if the metal pillar is canceled and the micro hole is directly filled after laser forming, except for the above short circuit risk caused by the slurry filled into the rest three-dimensional circuit layers, in a scenario where a fine circuit is printed, as the width, thickness (for example, only a few microns) and other sizes of the circuit are small compared with the micro hole, the circuit at the bottom of the micro hole is easy to fully ablate by laser, resulting in absence of contact or little contact between the filled slurry and metal circuits during filling (it is conceivable that laser drilling is conducted above a thin metal circuit; the size of the hole is much larger than the width of the fine circuit, and the circuit at the bottom of the micro hole is easy to fully ablate by laser, resulting in absence of contact or little contact between the filled slurry and metal circuit during filling), and conduction cannot be ensured. The hole surface is filled with the filling slurry after filling of the micro hole, and the extrusion amount for filling is controlled such that the filling slurry on the hole surface is basically flush with the hole. For the scenario that the micro hole is filled by the precision pneumatic extrusion method, air pressure ranges from 5 psi to 80 psi, the depth of a printer head into the hole ranges from 5 µm to 400 µm, and a pulling speed of the printer head ranges from 0.01 mm/s to 5 mm/s. Post-treatment of the micro hole filling slurry is similar to that of the three-dimensional circuit layer and the metal pillar as described above, and the filling slurry needs to be shaped by pre-curing.

### Lead wire:

The lead wire is used for electrically connecting the metal pillar at the bottom layer of the vertical interconnect structure to the top three-dimensional circuit layer. In the first vertical interconnect structure, a precision pneumatic printer head moves to a position of a certain height (which is related to the requirement of interconnect precision, and generally ranges from 3 µm to 5 µm if the width of the lead wire ranges from 5 µm to 10 µm and the diameter of the micro hole is 40 µm ± 5 µm) above the hole during lead-out operation. After stringy extruded slurry is in full contact with the hole surface, the printer head moves to lead the lead wire out of the hole for interconnection of the circuits of the upper three-dimensional circuit layers. The starting stage of the lead wire is a key step. A printing path at the starting stage needs to be deflected in a Z direction to compensate local bulge of the insulating layer. Meanwhile, in order to improve reliability of a vertical conduction structure, the printing speed should be increased slowly, to achieve the gradual changing effect that the line width (approximately equal to the size of the micro hole, as shown in FIG. 6 and FIG. 8) is larger at the starting point and the line width (approximately equal to the line width at the three-dimensional circuit layer) is small by the tail end of lead-out. As a regulation process is provided between the thickness of the insulating layer and the height of the metal pillar in the first vertical interconnect structure, the effect on the bulge of the upper insulating layer may be controlled effectively. The printer head only needs to slightly deflect from the movement path in the Z direction during lead-out, and then the distance between the printer head and the substrate surface may be ensured within a normal printing range (for the metal pillar with a height of 10 µm and a sintered polyimide insulating layer with a thickness of 20 µm, the surface of the insulating layer right above the metal pillar is generally 3-5 µm higher than that of the insulating layer far away from the metal pillar). An initial printing speed at the initial segment of the lead wire is generally 0.01 mm/s, and the printer head starts at this speed to slowly speed up, moves horizontally and deflects in a Z direction. In the first vertical interconnect structure, such horizontal displacement generally ranges from 10 µm to 50 µm. After completion of horizontal displacement and Z-direction deflection, the printer head may quickly speed up to the speed of a normal printed circuit.

In the second vertical interconnect structure, there are no micro hole and filling structure, the metal pillar is higher than the cured insulating layer and the planeness of the upper surface of the metal pillar is no more than 2 µm, and therefore the printer head may directly move to the upper surface of the metal pillar as the lead wire. Due to influence of the height of the metal pillar and surface tension of coating liquid, the surface of the insulating layer within a small area (generally within a radius of 100 µm for the metal pillar with a diameter ranging from 45 µm to 55 µm) around the metal pillar has curves, and the height of the surface decreases significantly from the near to the remote. The printer head should be matched with the height difference between the upper surface of the metal pillar and the surface of the insulating layer far away from the metal pillar in the Z direction during printing after lead-out from the surface of the metal pillar, to ensure that the lead wire is led out of the upper surface of the metal pillar to the insulating layer beyond the small area around the metal pillar by the printer head at a time for interconnection of the circuits of the upper 3D circuit layers. An initial printing speed at the initial segment of the lead wire is generally 0.01 mm/s, and the printer head starts at this speed to slowly speed up, moves horizontally and deflects in a Z direction. In the second vertical interconnect structure, such horizontal displacement generally ranges from 20 µm to 100 µm. After completion of horizontal displacement and Z-direction deflection, the printer head may quickly speed up to the speed of a normal printed circuit.

The preparation process of the multilayer PCB and the vertical interconnect structure stated in the present disclosure will be described more detailedly with reference to the corresponding drawings of the specification:
FIG. 5 and FIG. 6 show a first vertical interconnect structure. A metal pillar 4 is smaller in size, and is covered with an insulating layer 3. An extension part 5 of the metal pillar 4 is formed by filling a micro hole 7 in the insulating layer 3, and the extension part 5 is connected with a circuit of an upper three-dimensional circuit layer 2 by a lead wire 6 to achieve connection.

FIG. 7 and FIG. 8 show a second vertical interconnect structure. The metal pillar 4 is larger in size. The insulating layer 3 shrinks after curing, and therefore the surface of the metal pillar 4 penetrates through the insulating layer 3. The metal pillar 4 is directly connected with the circuit of an upper three-dimensional circuit layer 2 by the lead wire 6 to achieve connection.

FIG. 9 shows interconnection between two adjacent three-dimensional circuit layers 2 by the first vertical interconnect structure. In this embodiment, the interconnection between two adjacent three-dimensional circuit layers 2 is used to explain step 3 "the corresponding metal pillar is led out of the formed insulating layer in advance by drilling a hole in the insulating layer and filling the drilled hole with the nanoscale metal slurry according to the connection requirements of the 3D circuit layers and the heights of the metal pillars on the 3D circuit layers": firstly, a first three-dimensional circuit layer 2 is printed, and a metal pillar 4 is printed at a preset position according to the connection requirements of the first three-dimensional circuit layer 2; then, a first insulating layer 3 is formed on the first three-dimensional circuit layer 2, and at the moment as the first three-dimensional circuit layer 2 needs to be connected with a subsequent second three-dimensional circuit layer 2 to be formed, and the metal pillar 4 on the first three-dimensional circuit layer 2 is lower than the first insulating layer 3, the metal pillar 4 on the first three-dimensional circuit layer 2 needs to be led out of the first insulating layer 3 in advance by drilling a hole on the first insulating layer 3 and filling the drilled hole with the nanoscale metal slurry (the nanoscale metal slurry is filled to form the extension part 5); the lead wire 6 is printed on the extension part 5 (it should be noted that if the metal pillar 4 on the first three-dimensional circuit layer 2 is higher than the first insulating layer 3, drilling and filling are not required, and the lead wire 6 is directly printed on the metal pillar 4); and furthermore, the second three-dimensional circuit layer 2 is formed on the first insulating layer 3, and then the lead wire 6 is connected to a circuit of the second three-dimensional circuit layer 2 to achieve interconnection.

It should be noted that the present disclosure applies the method of leading out the metal pillar 4 in advance other than leading out the metal pillar 4 needing to be connected to the three-dimensional circuit layer 2 after formation of the three-dimensional circuit layer 2, which can avoid influence of drilling and filling processes on the three-dimensional circuit layer 2, to ensure the interconnect precision of the multilayer PCB.

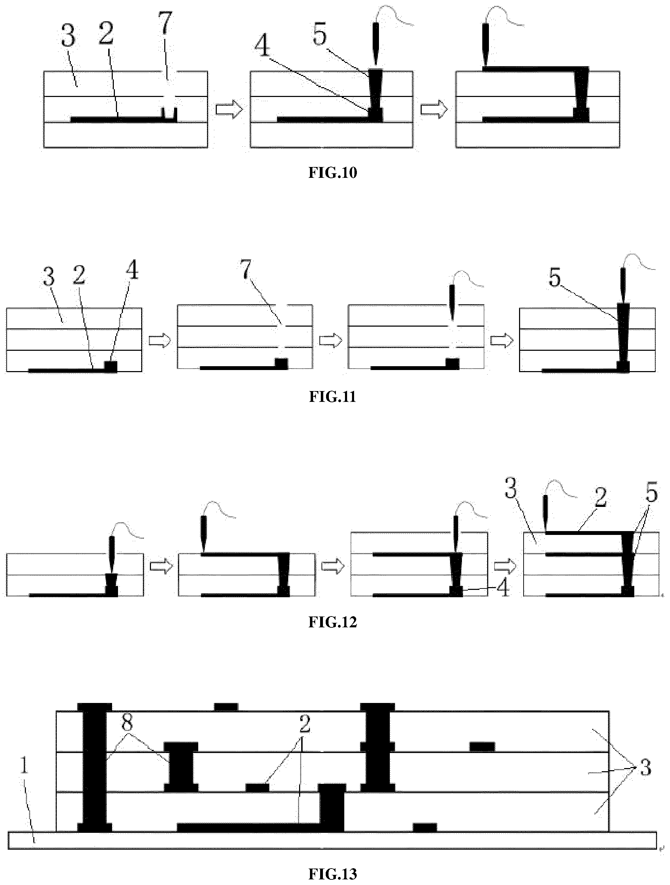

FIG. 10 and FIG. 11 show interconnection between three-dimensional circuit layers 2 spaced by multiple layers through the first vertical interconnect structure.

FIG. 12 shows interconnection of a plurality of three-dimensional circuit layers 2 on the same vertical line. As shown in the figure, after the first and third three-dimensional circuit layers 2 are connected by printing the metal pillar 4, filling the extension part 5 and printing the lead wire 6, if the connection position also needs to be connected with a fourth three-dimensional circuit layer 2, the other extension part 5 may be formed at the position of the lead wire 6 on the third three-dimensional circuit layer 2 by drilling a micro hole 7 and filling the drilled hole with the slurry, and additional preset of the metal pillar 4 is not required. As the line width (approximately equal to the size of the micro hole 7, as shown in FIG. 6 and FIG. 8) at the lead-out starting point of the lead wire 6 is larger, the above non-conduction phenomenon will not appear.

It should be noted that in the manufacturing process of the multilayer PCB, the form of the vertical interconnect structure may be selected according to the connection requirements. For example, if only interconnection between adjacent 3D circuit layers 2 needs to be achieved, the second vertical interconnect structure may be selected directly; and if interconnection between the 3D circuit layers 2 spaced by multiple layers needs to be achieved, the first vertical interconnect structure may be selected.

FIG. 13 shows an overall effect of the high-precision multilayer PCB after connection.

The specific preparation process of the high-precision multilayer PCB is given below (it should be noted that the preparation process of a pad layer is omitted in the following preparation process to facilitate description):
First stage: printing design of a multilayer PCB:
   step 1. The printer head type, medium materials and printing materials are determined according to the design information (line width and line spacing, stack design, impedance design and vertical interconnect design position) of the multilayer PCB, whereby a multilayer PCB including a total of 4 three-dimensional circuit layers with a line width of 5 µm, line spacing of 5 µm and a line height of 3 µm and 4 polyimide insulating layers (with a thickness of 18 µm) are taken as an example;
   step 2. a DXF design drawing is imported into process supporting CAM software. The CAM software generates a printing path code for each circuit layer, and a coating thickness and area for each insulating dielectric layer. A preset position of a vertical interconnect structure of each three-dimensional circuit layer is determined according to the connection requirements of the multilayer PCB;
   step 3. the printing path is checked and corrected, and a coating tool bit is corrected (see above for the correction method);
second stage: feeding and mill preparation:
   step 1. a nanoscale silver slurry material with shear thinning characteristics is used, a viscosity is 580,000 cps, a metal solid content is 85%, a thixotropic index is 9, a height-width ratio of a line is 0.5, and the material may be resistant to stripping by a 3M Scotch 600 adhesive tape; a standard polyimide liquid material is used as a coating medium material, a viscosity is 10,000 cps, and a metal solid content is 18%; a glass needle with an inner diameter of 5 µm and an outer diameter of 10 µm is used, and the planeness of an end face is no more than 1 µm; a metal scraper is used as a coating head;
   step 2. a reservoir filled with the nanoscale silver slurry material is installed on a precision pneumatic dispensing machine, and a reservoir filled with the coating medium material is installed in a precision metering feeder;
   step 3. a polyimide film substrate with overall dimensions of 200 mm*200 mm*0.25 mm is fed automatically/manually in a feeding area, the CAM software is started, vacuum adsorption is enabled, the substrate is adsorbed by a sample stage, and equipment mechanically returns to zero;
   step 4. the whole substrate printing area is scanned by a laser displacement sensor (the measurement resolution is 0.3 µm), and heights of all point positions on the upper surface of the substrate are measured to obtain a height data set of the upper surface of the substrate; the CAM software records the height data set of the substrate;
   step 5. the precision pneumatic dispensing machine is turned on in a preprinting area, and an output air pressure and a print moving speed are set in the CAM software. The printer head is controlled to descend by the software, till the distance between the printer head and the silicon substrate in the preprinting area is 3 µm, and a line is preprinted under different air pressures and moving speeds. The pressure and speed parameters corresponding to the line width of 5±0.5 µm are recorded. In this embodiment, the pressure is 45 psi, and the speed is 0.5 mm/s; then, a relative height difference between the print starting point on the polyimide substrate and the preprinting silicon substrate is measured and recorded by the laser displacement sensor;
third stage: preparation of the multilayer PCB:
   step 1. after the printer head is transferred to the print starting point, the height of the printer head in the Z axis is regulated according to the relative height difference obtained in step 5 at the second stage, till the distance between the printer head and the silicon substrate is equal to the distance between the printer head and the silicon substrate in the preprinting area during preprinting. Compensation needs to be enabled before printing; meanwhile, as the laser displacement sensor has recorded the height data set of the substrate in the software, height fluctuation of the substrate surface is automatically compensated by lifting the sample stage, and the distance between the printer head and the substrate is kept at 3 µm in the printing process;
   step 2. a first three-dimensional circuit layer is printed according to the printing path generated at the first stage and the printing parameters obtained at the second stage;
   step 3. a metal pillar is printed at the position of vertical interconnect, and a cross mark point is printed at a mark point position. The metal pillar is prepared by repeatedly filling the circuit layer upon layer. Hatch spacing of filling lines in each layer is 5 µm, and a centre-to-centre distance between layers is 3 µm. The final length, width and height of the metal pillar after multilayer stacking are 50 µm*50 µm*12 µm; the metal circuit and pillar are pre-cured by a heating ceramic sucker integrated with equipment at 150°C for 10 min, and cooled after pre-curing;
   step 4. the sample stage is moved to a starting position of coating, and a clearance between the scraper and the substrate is regulated according to the required coating thickness (100 µm) of the current layer generated at the first stage (see above for the clearance regulation method). The polyimide liquid material is coated on a position 5 mm in front of the scraper by a dispensing method, and a moving speed of the sample stage is set to 1 mm/s. The polyimide material is pushed by the scraper relative to the sample stage to form a wet film on the substrate, and the wet film stands for 60 s.
   step 5. the wet film is cured by the heating ceramic sucker integrated with equipment, and changed to a dry film. The dry film is cured at 70°C for 10 min, then cured at 150°C for 10 min, and cooled after curing.
   step 6. the sample stage is moved to a micro hole molding position, and a relative position relation is corrected by visually grabbing the mark point. Then, the micro hole is drilled by laser right above the metal pillar to break the insulating layer right above the metal pillar. The used laser source is 355 nm ultraviolet picosecond laser, an average power is 4 W, a pulse width is smaller than 15 ps, a repetition frequency is 1 Mhz, a helical scanning speed is 0.5 mm/s, a jump speed is 100 mm/s, a spot diameter is 20 µm, a diameter of the obtained hole is 40 µm, and a depth of the hole is 20 µm;
   step 7. the sample stage moves back to a printing position, the micro hole is filled with metal slurry by the printer head in a precision pneumatic extrusion manner. The used metal slurry is also the nanoscale silver slurry (diluted to a viscosity of 400,000 cps), the depth of the needle into the hole is 15 µm, air pressure is 40 psi, and a pulling speed is 0.05 mm/s. Then, the action of leading out a wire is done, an initial speed of leading out the wire is 0.01 mm/s, a horizontal displacement at the lead-out starting stage is 20 µm, and Z-direction deflection is 3 µm;
   step 8. a relative position relation is corrected by visually grabbing the mark point. A first layer of circuit is printed on the surface of the sintered polyimide insulating layer according to the printing path generated at the first stage and the printing parameters obtained at the second stage, and the metal pillar is printed at the position of vertical interconnect;
   step 9. step 3 to step 8 are repeated, till printing of 4 layers of circuits, and coating and curing of 4 insulating layers are completed;
   step 10. the overall multilayer PCB is completely cured by the heating ceramic sucker integrated with equipment at 250°C for 1 h;
   step 11. vacuum adsorption is shut off and cutting-off is done; and
   step 12. the multilayer PCB sample is tested and cut.

### Embodiment 2:

This embodiment is different from Embodiment 1 in that a slit coating method is adopted, and the specific improvement is as follows:
1. slit coating method: step 4 at the third stage in Embodiment 1 is changed as follows: the sample stage is moved to the starting position of the coating after printing, and a clearance between a slit coating head and the substrate is regulated to 100 µm according to the required coating thickness (100 µm) of the current layer generated at the first stage in Embodiment 1; an extrusion amount of the slit coating head is set to 2250 uL, an extrusion speed is set to 15 uL/s, and an average moving speed of the coating head relative to the substrate is set to 1 mm/s; the moving speed is slightly higher at the starting stage (1.2 mm/s, 5 s), and slightly lower at the end stage (0.7 mm/s, 5 s); then, the coating process is started to complete coating of the current insulating layer; and
2. the remaining stages and steps are kept consistent with those in Embodiment 1.

### Embodiment 3:

This embodiment is different from Embodiment 1 in terms of curing and sintering of the insulating medium material, and the specific improvement is as follows:
(1) Thermal curing of organic materials, polyimide:
   1. step 5 at the third stage in Embodiment 1 is changed as follows: the medium is pre-cured by an infrared lamp integrated with equipment under 600 w for 30 s;
   2. step 10 at the third stage in Embodiment 1 is changed as follows: the overall multilayer PCB is completely cured and sintered by an infrared lamp integrated with equipment under 3000 w for 20 s;
   3. step 10 at the third stage in Embodiment 1 is changed as follows: vacuum adsorption is shut off and the substrate is cut off; and the overall multilayer PCB is completely cured by an off-line muffle furnace at 250°C for 1 h; and
   4. The remaining stages and steps are kept consistent with those in Embodiment 1.
(2) Photocuring of organic materials, photosensitive epoxy resin:
   1. step 5 at the third stage in Embodiment 1 is changed as follows: the medium is pre-cured by an ultraviolet curing lamp integrated with equipment;
   2. Step 10 at the third stage in Embodiment 1 is changed as follows: the medium is completely cured by the ultraviolet curing lamp integrated with equipment, and the circuit is completely cured by the infrared lamp or the heating ceramic sucker integrated with equipment;
   3. step 10 at the third stage in Embodiment 1 may also be changed as follows: vacuum adsorption is shut off and the substrate is cut off; the medium is completely cured by an off-line ultraviolet curing lamp, and the circuit is completely cured by the off-line muffle furnace and the infrared lamp; and
   4. the remaining stages and steps are kept consistent with those in Embodiment 1.
(3) Ceramic sintering, alumina ceramic:
   1. step 5 at the third stage in Embodiment 1 is changed as follows: the medium is pre-sintered by the heating ceramic sucker integrated with equipment at 200°C for 5 min;
   2. step 10 at the third stage in Embodiment 1 is changed as follows: vacuum adsorption is shut off and cutting-off is done; and a ceramic sample is co-fired overall at low temperature by an off-line muffle furnace (at 850°C for 2 h); and
   3. the remaining stages and steps are kept consistent with those in Embodiment 1.

### Embodiment 4:

This embodiment is different from Embodiment 1 in that the metal circuit and the metal pillar are sintered by laser, and the insulating medium is completely cured in a protective atmosphere; the specific improvement is as follows:
(1) Polyimide which needs to be cured at high temperature in a nitrogen environment:
   1. step 3 at the third stage in Embodiment 1 is changed as follows: the metal pillar is printed at the position of vertical interconnect, and the cross mark point is printed at the mark point position. The metal pillar is prepared by repeatedly filling the circuits layer upon layer. Hatch spacing of filling lines in each layer is 5 µm, and a centre-to-centre distance between layers is 3 µm. The final length, width and height of the metal pillar after multilayer stacking are 50 µm*50 µm*12 µm. Selective sintering is conducted on the metal circuit and pillar by a fiber output semiconductor laser device integrated with equipment, a wave length of laser emitting from the laser device is 915 nm, the maximum power is 50 W, and the minimum diameter of a light spot is 200 µm. The light spot does translation at 1 mm/s in a metal circuit area along the path of the circuit. The light spot does translation along an outer frame line of the pillar at 1 mm/s under 5 W firstly, then does reciprocating translation along a filling line path of the pillar at 2 mm/s under 25 W in a pillar area. The laser-sintered metal circuit and pillar have electrical conductivity.
   2. step 10 at the third stage in Embodiment 1 is changed as follows: vacuum adsorption is shut off and the substrate is cut off; the insulating medium of the multilayer PCB is completely cured by the off-line nitrogen sintering furnace at 350°C for 1 h, an oxygen content is no more than 20 ppm, and a heating rate is 5 °C/min; and
   3. the remaining stages and steps are kept consistent with those in Embodiment 1.

### Embodiment 5:

This embodiment is different from Embodiment 1 in that the printing material is changed to nanoscale copper slurry, and the specific improvement is as follows:
1. step 1 at the second stage in Embodiment 1 is changed as follows: a nanoscale silver slurry material with shear thinning characteristics is used, a viscosity is 580,000 cps, a metal solid content is 80%, a thixotropic index is 9, a height-width ratio of a line is 0.5, and the material may be resistant to stripping by a 3M Scotch 600 adhesive tape; a standard polyimide liquid material is used as a coating medium material, a viscosity is 10,000 cps, and an effective content is 18%; a glass needle with an inner diameter of 5 µm and an outer diameter of 10 µm is used, and the planeness of an end face is no more than 1 µm; a metal scraper is used as a coating head;
2. step 3 at the third stage in Embodiment 1 is changed as follows: the metal pillar is printed at the position of vertical interconnect, and the cross mark point is printed at the mark point position. The metal pillar is prepared by repeatedly filling the circuits layer upon layer. Hatch spacing of filling lines in each layer is 5 µm, and a centre-to-centre distance between layers is 3 µm. The final length, width and height of the metal pillar after multilayer stacking are 50 µm*50 µm*12 µm; the metal circuit and pillar are pre-cured by a heating ceramic sucker integrated with equipment at 100°C for 8 min, and cooled after pre-curing;
3. step 7 at the third stage in Embodiment 1 is changed as follows: the sample stage moves back to a printing position, the micro hole is filled with metal slurry by the printer head in a precision pneumatic extrusion manner. The metal slurry is also the nanoscale copper slurry (diluted to a viscosity of 400,000 cps). The depth of the printer head into the hole is 15 µm, air pressure is 40 psi, a pulling speed is 0.05 mm/s. Then, the action of leading out a wire is done, an initial speed of leading out the wire is 0.01 mm/s, a horizontal displacement at the lead-out starting stage is 20 µm, and Z-direction deflection is 3 µm;
4. step 10 at the third stage in Embodiment 1 is changed as follows: vacuum adsorption is shut off and the substrate is cut off; the overall multilayer PCB is completely cured by the off-line nitrogen sintering furnace at 300°C for 1 h, the oxygen content is no more than 20 ppm, and a heating rate is 5 °C/min; and
5. the remaining stages and steps are kept consistent with those in Embodiment 1.

The above described embodiments are merely a description of preferred embodiments of the present disclosure, and are limited by the appended claims.

## Claims

1. A 3D printing preparation method of a high-precision multilayer PCB, comprising the steps:
S1. extruding a nanoscale metal slurry with shear thinning characteristics from an extrusion nozzle, to form a three-dimensional circuit layer (2) on an upper surface of a substrate (1);
S2. extruding the nanoscale metal slurry with shear thinning characteristics from the extrusion nozzle, to form a metal pillar (4) at a preset position of the current three-dimensional circuit layer (2) by stacking;
S3. forming an insulating layer (3) on an upper surface of the current three-dimensional circuit layer (2) as well as on the previously made exposed insulating layer, and leading the corresponding metal pillar (4) out of the formed in advance insulating layer by drilling a hole in the insulating layer (3) and filling the drilled hole with the nanoscale metal slurry, wherein the insulating layer (3) right above the metal pillar (4) is broken by a laser drilling method to form the micro hole (7), and the laser drill line by line is based on visual positioning;
S4. judging whether the current insulating layer acts as a top insulating layer; forming a pad layer on an upper surface of the current insulating layer and executing step S5A if yes; repeatedly executing steps S1 and S2 once by using the current insulating layer as a new substrate, and executing step S5B if not;
S5A. connecting the metal pillar located on the corresponding three-dimensional circuit layer right below the current insulating layer or leading it out in advance and connecting to the pad layer, to complete the preparation of the multilayer PCB; and
S5B. connecting the metal pillar located on the corresponding three-dimensional circuit layer right below the current insulating layer or leading it out in advance and connecting to the current three-dimensional circuit layer, and returning to step S3;
wherein the three-dimensional circuit layer (2) of said high-precision multilayer PCB has:
- a line width that ranges from 1 µ m to 150 µm,
- a line spacing that ranges from 1 µ m to 150 µm,
- a size of the vertical interconnect structure, which is formed by combining a metal pillar (4), micro hole (7), an extension part (5) of the metal pillar and lead wire (6), ranges from 20 µm to 150 µm, and
- a spacing there between the vertical interconnect structures that ranges from 20 µm to 150 µm;
wherein between step S2 and step S3, the method further comprises the steps of:
first pre-curing treatment to the current three-dimensional circuit layer and the metal pillar formed at the preset position of the current three-dimensional circuit layer by stacking;
second pre-curing treatment to the insulating layer in step S3 after the insulating layer is formed on the upper surface of the current three-dimensional circuit layer;
third pre-curing treatment to the filled nanoscale metal slurry in step S3 after the holes are drilled on the insulating layer and filled with the nanoscale metal slurry; and
integrated sintering and curing treatment to the multilayer PCB to complete preparation of the multilayer PCB in step S5A after the metal pillar on the corresponding three-dimensional circuit layer right below the current insulating layer is connected or lead out in advance and connected to the pad layer; and wherein in step S1, the formation of the three-dimensional circuit layer on the upper surface of the substrate comprises:
measuring heights of all point positions on the upper surface of the substrate, to obtain a height data set of the upper surface of the substrate, and making the extrusion nozzle do relative motion in a Z-axis direction at the corresponding point position on the upper surface of the substrate according to the height data set of the upper surface of the substrate when the nanoscale metal slurry with shear thinning characteristics is extruded from the extrusion nozzle, so that the nanoscale metal slurry with shear thinning characteristics extruded from the extrusion nozzle forms the three-dimensional circuit layers on the upper surface of the substrate.

2. The 3D printing preparation method of the high-precision multilayer PCB according to claim 1, wherein
in step S1, the extrusion nozzle does curvilinear pre-extrusion motion on a plane perpendicular to the substrate before the nanoscale metal slurry with shear thinning characteristics is extruded from the extrusion nozzle to form a starting end of each circuit in the three-dimensional circuit layers, and the extrusion nozzle moves along a formal extrusion forming route of the circuit in a tangent direction of the curve; and
in step S1, a preset anti-spattering section is disposed at a tail end of the formal extrusion forming route of the circuit, and the action of extruding the nanoscale metal slurry with shear thinning characteristics is cut off when the extrusion nozzle is located at the anti-spattering section.

3. The 3D printing preparation method of the high-precision multilayer PCB according to claim 1, wherein in step S2, the nanoscale metal slurry with shear thinning characteristics is extruded from the extrusion nozzle, to alternatively form outer frame lines and filling lines on each layer of the metal pillars, so that the metal pillar is formed at the preset position of the current three-dimensional circuit layer by stacking.

4. The 3D printing preparation method of the high-precision multilayer PCB according to claim 1, wherein in step S3, the formation method of the insulating layer comprises:
pushing an insulating medium material pre-applied to a coating surface by a scraper coating tool bit or extruding the insulating medium material onto the coating surface by a slit coating tool bit, to form the insulating layer on the upper surface of the current three-dimensional circuit layer.

5. The 3D printing preparation method of the high-precision multilayer PCB according to claim 4, wherein step S3 further comprises the following steps before coating of the insulating layer:
a. controlling a Z-axis motor to descend the coating tool bit so that a left end and a right end thereof get in touch with a contact sensor, respectively;
b. recording different heights of the Z-axis motor respectively when the left end and right end of the coating tool bit trigger the contact sensor to emit signals, to obtain a height difference between the left end and right end of the coating tool bit; and
c. correcting the heights of the left end and right end of the coating tool bit according to the height difference between the left end and right end of the coating tool bit.

6. The 3D printing preparation method of the high-precision multilayer PCB according to claim 4, wherein step S3 further comprises the following steps before coating of the insulating layer:
A. detecting a height of a contact surface of the contact sensor by a laser displacement sensor, to obtain the height of the contact sensor;
B. detecting a height of a starting point of coating on the coating surface by the laser displacement sensor, to obtain the height of the starting point of coating;
C. calculating a relative height difference between the contact sensor and the starting point of coating according to the height of the contact sensor and the starting point of coating;
D. making a centre of the coating tool bit with inclination corrected contact with the contact sensor, and recording the height of the coating tool bit in a Z axis during touching; and
E. correcting the height of the coating tool bit in the Z axis according to the relative height difference between the contact sensor and the starting point of coating, the height of the coating tool bit in the Z axis during touching of the coating tool bit with the contact sensor, and a preset coating clearance.

7. The 3D printing preparation method of the high-precision multilayer PCB according to claim 1, wherein step S3 comprises the specific steps:
S3.1. forming the insulating layer on the upper surface of the current three-dimensional circuit layer and
S3.2. leading the corresponding metal pillar out of the formed insulating layer in advance by drilling a hole in the insulating layer and filling the drilled hole with the nanoscale metal slurry according to the connection requirements of the three-dimensional circuit layers and the height of the metal pillar on each three-dimensional circuit layer.

8. The 3D printing preparation method of the high-precision multilayer PCB according to claim 1, wherein the nanoscale metal slurry with shear thinning characteristics comprises silver or copper nanoparticles and a dispersion medium, and a content of the metal nanoparticles ranges from 75% to 95%; a viscosity of the nanoscale metal slurry with shear thinning characteristics ranges from 100,000 cps to 1,000,000 cps, and a thixotropic index ranges from 4 to 10; and a height-width ratio of the line formed by the nanoscale metal slurry with shear thinning characteristics is no less than 0.5.

9. The 3D printing preparation method of the high-precision multilayer PCB according to claim 8, wherein the dispersion medium comprises a dispersion solvent and a binder, and the dispersion solvent comprises any one or more of an organic solvent and water; and the binder comprises any one or more of a polyacrylic acid, a diethanolamine and a complex of the polyacrylic acid and the diethanolamine; or the binder comprises an epoxy resin, a curing agent and a protective agent.

10. The 3D printing preparation method of the high-precision multilayer PCB according to claim 9, wherein the organic solvent comprises any one or more of ethylene glycol, glycerol, diethylene glycol monoethyl ether acetate, dibasic ester, isophoron, terpineol or diethylene glycol monobutyl ether, the protective agent is formed by any one or a combination of more of a triarylphosphine compound and a trialkylphosphine compound; the epoxy resin comprises any one or more of a bisphenol A-type epoxy resin, an E-44 epoxy resin and a biphenoxy epoxy resin; and the curing agent is any one of a polythiol curing agent, a dicyandiamide curing agent and an anhydride curing agent.

11. The 3D printing preparation method of the high-precision multilayer PCB according to claim 1, wherein the insulating layer is made from organic or ceramic dielectric.

## Patentansprüche

1. Vorbereitungsverfahren für einen 3D-Druck einer hochpräzisen Mehrschichtleiterplatte, umfassend die Schritte:
S1. Extrudieren einer nanoskaligen Metallsuspension mit Scherverdünnungseigenschaften aus einer Extrusionsdüse, um eine dreidimensionale Schaltungsschicht (2) auf einer Oberfläche eines Substrats (1) zu bilden;
S2. Extrudieren der nanoskaligen Metallsuspension mit Scherverdünnungseigenschaften aus der Extrusionsdüse, um einen Metallpfeiler (4) an einer vorgegebenen Position der aktuellen dreidimensionalen Schaltungsschicht (2) durch Stapeln zu bilden;
S3. Bilden einer Isolierschicht (3) auf einer Oberfläche der aktuellen dreidimensionalen Schaltungsschicht (2) sowie auf der zuvor hergestellten freiliegenden Isolierschicht und Führen des entsprechenden Metallpfeilers (4) aus der zuvor gebildeten Isolierschicht durch Bohren eines Lochs in der Isolierschicht (3) und Füllen des gebohrten Lochs mit der nanoskaligen Metallsuspension, wobei die Isolierschicht (3) direkt oberhalb des Metallpfeilers (4) durch ein Laserbohrverfahren gebrochen wird, um zur das Mikroloch (7) zu bilden, und das Laserbohren Zeile für Zeile auf visueller Positionierung basiert;
S4. Beurteilen, ob die aktuelle Isolierschicht als obere Isolierschicht wirkt; Bilden einer Pad-Schicht auf einer Oberfläche der aktuellen Isolierschicht und Ausführen von Schritt S5A, wenn ja; wiederholtes Ausführen der Schritte S1 und S2 einmal unter Verwendung der aktuellen Isolierschicht als neues Substrat und Ausführen des Schritts S5B, wenn nicht;
S5A. Verbinden des Metallpfeilers, die sich auf der entsprechenden dreidimensionalen Schaltungsschicht direkt unterhalb der aktuellen Isolierschicht befindet, oder vorzeitiges Herausführen und Verbinden des Metallpfeilers mit der Pad-Schicht, um die Vorbereitung der Mehrschichtleiterplatte abzuschließen; und
S5B. Verbinden des Metallpfeilers, die sich auf der entsprechenden dreidimensionalen Schaltungsschicht direkt unterhalb der aktuellen Isolierschicht befindet, oder vorzeitiges Herausführen und Verbinden des Metallpfeilers mit der aktuellen dreidimensionalen Schaltungsschicht, und Rückkehren zu Schritt S3;
wobei die dreidimensionale Schaltungsschicht (2) der hochpräzisen Mehrschichtleiterplatte aufweist:
- eine Linienbreite im Bereich von 1 µm bis 150 µm,
- einen Linienabstand im Bereich von 1 µm bis 150 µm,
- eine Größe der vertikalen Verbindungsstruktur, die durch Kombination eines Metallpfeilers (4), eines Mikrolochs (7), eines Verlängerungsteils (5) des Metallpfeilers und eines Leitdrahtes (6) gebildet wird und von 20 µm bis 150 µm reicht, und
- ein Abstand zwischen den vertikalen Verbindungsstrukturen, der zwischen 20 µm und 150 µm reicht;
wobei zwischen Schritt S2 und Schritt S3 das Verfahren ferner die Schritte umfasst:
eine erste Vorhärtungsbehandlung der aktuellen dreidimensionalen Schaltungsschicht und der an der vorgegebenen Position des aktuellen dreidimensionalen Schaltungsschicht gebildeten Metallpfeilers durch Stapeln;
eine zweite Vorhärtungsbehandlung der Isolierschicht in Schritt S3, nachdem die Isolierschicht auf der Oberfläche der aktuellen dreidimensionalen Schaltungsschicht ausgebildet ist;
eine dritte Vorhärtungsbehandlung der gefüllten nanoskaligen Metallsuspension in Schritt S3, nachdem die Löcher in der Isolierschicht gebohrt und mit der nanoskaligen Metallsuspension gefüllt wurden; und
integrierte Sinter-und Aushärtungsbehandlung an die Mehrschichtleiterplatte, um die Vorbereitung der Mehrschichtleiterplatte in Schritt S5A abzuschließen, nachdem der Metallpfeiler auf der entsprechenden dreidimensionalen Schaltungsschicht direkt unterhalb der aktuellen Isolationsschicht vorab verbunden oder herausgeführt und mit der Pad-Schicht verbunden ist;
und wobei in Schritt S1 die Bildung der dreidimensionalen Schaltungsschicht auf der Oberfläche des Substrats umfasst:
Messen von Höhen aller Punktpositionen auf der Oberfläche des Substrats, um einen Höhendatensatz der Oberfläche des Substrats zu erhalten und Veranlassen der Extrusionsdüse, eine relative Bewegung in Z-Achsenrichtung an der entsprechenden Punktposition auf der Oberfläche des Substrats gemäß dem Höhendatensatz der Oberfläche des Substrats, wenn die nanoskalige Metallsuspension mit Scherverdünnungseigenschaften aus der Extrusionsdüse extrudiert wird, so dass die aus der Extrusionsdüse extrudierte nanoskalige Metallsuspension mit Scherverdünnungseigenschaften die dreidimensionalen Schaltungsschichten auf der Oberfläche des Substrats bildet.

2. Vorbereitungsverfahren für den 3D-Druck der hochpräzisen Mehrschichtleiterplatte nach Anspruch 1, wobei
in Schritt S1 die Extrusionsdüse eine kurvenförmige Vorextrusionsbewegung auf einer Ebene senkrecht zum Substrat ausführt, bevor die nanoskalige Metallsuspension mit Scherverdünnungseigenschaften aus der Extrusionsdüse extrudiert wird, um ein Startende jedes Schaltkreises in den dreidimensionalen Schaltungsschichten zu bilden, und die Extrusionsdüse sich entlang einer formalen Extrusionsbildungsstrecke des Schaltkreises in einer Tangentialrichtung der Kurve bewegt; und
in Schritt S1 ein vorgegebenener Spritzschutzabschnitt an einem hinteren Ende des formellen Extrusionsbildungsweges des Schaltkreises angeordnet ist, und die Wirkung des Extrudierens der nanoskaligen Metallsuspension mit Scherverdünnungseigenschaften wird unterbrochen, wenn sich die Extrusionsdüse an dem Spritzschutzabschnitt befindet.

3. Vorbereitungsverfahren für den 3D-Druck der hochpräzisen Mehrschichtleiterplatte nach Anspruch 1, wobei in Schritt S2 die nanoskalige Metallsuspension mit Scherverdünnungseigenschaften aus der Extrusionsdüse extrudiert wird, um alternativ äußere Rahmenlinien und Fülllinien auf jeder Schicht der Metallpfeiler zu bilden, so dass der Metallpfeiler an der vorgegebenen Position der aktuellen dreidimensionalen Schaltungsschicht durch Stapeln gebildet wird.

4. Vorbereitungsverfahren für den 3D-Druck der hochpräzisen Mehrschichtleiterplatte nach Anspruch 1, wobei in Schritt S3 das Bildungsverfahren der Isolierschicht umfasst:
Drücken eines auf eine Beschichtungsfläche vorgebrachten Isoliermediummaterials durch einen Schaberbeschichtungswerkzeugbit oder Extrudieren des Isoliermediummaterials durch einen Schlitzbeschichtungswerkzeugbit auf die Beschichtungsfläche, um die Isolierschicht auf der Oberfläche der aktuellen dreidimensionalen Schaltungsschicht zu bilden.

5. Vorbereitungsverfahren für den 3D-Druck der hochpräzisen Mehrschichtleiterplatte nach Anspruch 4, wobei Schritt S3 ferner die folgenden Schritte vor dem Beschichten der Isolierschicht umfasst:
a. Steuern eines Z-Achsenmotors zum Absenken des Beschichtungswerkzeugbits, so dass ein linkes Ende bzw. ein rechts Ende desselben jeweils mit einem Kontaktsensor in Kontakt kommen;
b. Aufzeichnen unterschiedlicher Höhen des Z-Achsenmotors, wenn das linke Ende und das rechte Ende des Beschichtungswerkzeugbits den Kontaktsensor zum Aussenden von Signalen auslösen, um eine Höhendifferenz zwischen dem linken Ende und dem rechten Ende des Beschichtungswerkzeugbits zu erhalten; und
c. Korrigieren der Höhen des linken und rechten Endes des Beschichtungswerkzeugbits entsprechend der Höhendifferenz zwischen dem linken und rechten Ende des Beschichtungswerkzeugbits.

6. Vorbereitungsverfahren für den 3D-Druck der hochpräzisen Mehrschichtleiterplatte nach Anspruch 4, wobei Schritt S3 ferner die folgenden Schritte vor dem Beschichten der Isolierschicht umfasst:
A. Erfassen einer Höhe einer Kontaktfläche des Kontaktsensors durch einen Laserverschiebungssensor, um die Höhe des Kontaktsensors zu ermitteln;
B. Erfassen einer Höhe eines Ausgangspunktes der Beschichtung auf der Beschichtungsoberfläche durch den Laserverschiebungssensor, um die Höhe des Ausgangspunktes der Beschichtung zu ermitteln;
C. Berechnen einer relativen Höhendifferenz zwischen dem Kontaktsensor und dem Ausgangspunkt der Beschichtung entsprechend der Höhe des Kontaktsensors und dem Ausgangspunkt der Beschichtung;
D. Herstellen einer Mitte des Beschichtungswerkzeugbits mit neigungskorrigiertem Kontakt mit dem Kontaktsensor und Aufzeichnen der Höhe des Beschichtungswerkzeugbits in einer Z-Achse beim Berühren; und
E. Korrigieren der Höhe des Beschichtungswerkzeugbits in der Z-Achse entsprechend der relativen Höhendifferenz zwischen dem Kontaktsensor und dem Ausgangspunkt der Beschichtung, der Höhe des Beschichtungswerkzeugbits in der Z-Achse beim Berühren des Beschichtungswerkzeugbits mit dem Kontaktsensor und einem vorgegebenen Beschichtungsspiel.

7. Vorbereitungsverfahren für den 3D-Druck der hochpräzisen Mehrschichtleiterplatte nach Anspruch 1, wobei Schritt S3 die spezifischen Schritte umfasst:
S3.1. Bilden der Isolierschicht auf der Oberfläche der aktuellen dreidimensionalen Schaltungsschicht und
S3.2. Führen des entsprechenden Metallpfeilers aus der gebildeten Isolierschicht voraus durch Bohren eines Loches in der Isolierschicht und Füllen des gebohrten Loches mit der nanoskaligen Metallsuspension entsprechend den Verbindungsanforderungen der dreidimensionalen Schaltungsschichten und der Höhe des Metallpfeilers auf jeder dreidimensionalen Schaltungsschicht.

8. Vorbereitungsverfahren für den 3D-Druck der hochpräzisen Mehrschichtleiterplatte nach Anspruch 1, wobei die nanoskalige Metallsuspension mit Scherverdünnungseigenschaften Silber- oder Kupfernanopartikel und ein Dispersionsmedium umfasst und ein Gehalt der Metallnanopartikel von 75 % bis 95 % reicht; eine Viskosität der nanoskaligen Metallsuspension mit Scherverdünnungseigenschaften im Bereich von 100.000 cps bis 1.000.000 cps liegt und einen thixotropen index im Bereich von 4 bis 10 liegt; und ein Höhe-Breite-Verhältnis der durch die nanoskalige Metallsuspension gebildeten Linie mit Scherverdünnungseigenschaften nicht weniger als 0,5 beträgt.

9. Vorbereitungsverfahren für den 3D-Druck der hochpräzisen Mehrschichtleiterplatte nach Anspruch 8, wobei das Dispersionsmedium ein Dispersionslösungsmittel und ein Bindemittel umfasst und das Dispersionslösungsmittel eines oder mehrere eines organischen Lösungsmittels und Wasser umfasst; und das Bindemittel eines oder mehrere aus einer Polyacrylsäure, einem Diethanolamin und einem Komplex aus der Polyacrylsäure und dem Diethanolamin umfasst; oder das Bindemittel ein Epoxidharz, ein Härtungsmittel und ein Schutzmittel umfasst.

10. Vorbereitungsverfahren für den 3D-Druck der hochpräzisen Mehrschichtleiterplatte nach Anspruch 9, wobei das organische Lösungsmittel eines oder mehrere aus Ethylenglykol, Glycerin, Diethylenglykolmonoethyletheracetat, zweibasischem Ester, Isophoron, Terpineol oder Diethylenglykolmonobutylether umfasst und das Schutzmittel aus einem oder einer Kombination von mehreren aus einer Triarylphosphinverbindung und einer Trialkylphosphinverbindung gebildet wird; wobei das Epoxidharz eines oder mehrere von einem Bisphenol-A-Epoxidharz, einem E-44-Epoxidharz und einem Biphenoxy-Epoxidharz umfasst; und wobei das Härtungsmittel jedes eines Polythiol-Härtungsmittels, eines Dicyandiamid-Härtungsmittel und eines Anhydrid-Härtungsmittel ist.

11. Vorbereitungsverfahren für den 3D-Druck der hochpräzisen Mehrschichtleiterplatte nach Anspruch 1, wobei die Isolierschicht aus organischem oder keramischem Dielektrikum hergestellt ist.

## Revendications

1. Un procédé de préparation par impression tridimensionnelle d'un circuit imprimé multicouche de haute précision, **caractérisé en ce qu'**il comprend les étapes consistant à :
S1. extruder, au moyen d'une buse d'extrusion, une pâte métallique nanométrique avec des caractéristiques de rhéofluidification, afin de former une couche de circuit tridimensionnelle (2) sur la surface supérieure d'un substrat (1) ;
S2. extruder la pâte métallique nanométrique avec des caractéristiques de rhéofluidification afin de former, par empilement, un pilier métallique (4) à une position prédéterminée de la couche de circuit tridimensionnelle (2) courante ;
S3. former une couche isolante (3) sur la surface supérieure de la couche de circuit tridimensionnelle (2) courante ainsi que sur toute couche isolante exposée précédemment formée, puis réaliser un trou dans ladite couche isolante (3) et remplir le trou avec ladite pâte métallique afin de faire émerger le pilier métallique correspondant (4),
la couche isolante (3) située directement au-dessus du pilier métallique (4) étant percée par un procédé de perçage laser pour former un micro-trou (7), ledit perçage étant effectué ligne par ligne sur la base d'un positionnement visuel ;
S4. déterminer si la couche isolante courante constitue ou non une couche isolante supérieure, et dans l'affirmative, former d'une couche de pastille sur sa surface supérieure et exécution de l'étape S5A ; dans la négative, répéter des étapes S1 et S2 en utilisant ladite couche isolante comme nouveau substrat, puis exécution de l'étape S5B ;
S5A. connecter le pilier métallique, situé sur la couche de circuit tridimensionnelle correspondante immédiatement en dessous de la couche isolante courante, à la couche de pastille afin d'achever la fabrication du circuit imprimé multicouche ;
S5B. connecter le pilier métallique situé sur la couche de circuit tridimensionnelle correspondante juste en dessous de la couche isolante courante ou le diriger vers l'extérieur à l'avance, puis le connecter à la couche de circuit tridimensionnelle courante, puis retourner à l'étape S3; où
la couche de circuit tridimensionnelle (2) de dit circuit imprimé multicouche de haute précision présentant :
- une largeur de ligne comprise entre 1 µm et 150 µm ;
- un espacement de ligne compris entre 1 µm et 150 µm ;
- une dimension de structure d'interconnexion verticale formée par le pilier métallique (4), le micro-trou (7), une partie d'extension (5) et un conducteur (6), comprise entre 20 µm et 150 µm ; et
- un espacement entre lesdites structures compris entre 20 µm et 150 µm ;
où le procédé comprenant en outre, entre l'étape S2 et l'étape S3, les étapes suivantes:
un premier traitement de pré-réticulation de la couche de circuit tridimensionnelle courante et du pilier métallique formé à la position prédéfinie de la couche de circuit tridimensionnelle courante par empilement ;
un deuxième traitement de pré-réticulation de la couche isolante à l'étape S3, après la formation de la couche isolante sur la surface supérieure de la couche de circuit tridimensionnelle courante ;
un troisième traitement de pré-réticulation de la pâte métallique nanométrique remplie à l'étape S3, après que les trous ont été percés dans la couche isolante et remplis avec la pâte métallique nanométrique ; et
un traitement intégré de frittage et de durcissement du circuit imprimé multicouche pour compléter la préparation du circuit imprimé multicouche à l'étape S5A, après que le pilier métallique de la couche de circuit tridimensionnelle correspondante située directement sous la couche isolante courante a été connecté ou préalablement extrait et connecté à la couche de pastille ;
et où dans l'étape S1, la formation de la couche de circuit tridimensionnelle sur la surface supérieure du substrat comprend:
mesurer les hauteurs de l'ensemble des points sur la surface supérieure du substrat, afin d'obtenir un ensemble de données de hauteur de la surface supérieure du substrat, puis effectuer un mouvement relatif de la buse d'extrusion dans la direction de l'axe Z à la position correspondante sur la surface supérieure du substrat en fonction de l'ensemble de données de hauteur de la surface supérieure du substrat, de sorte que la pâte métallique nanométrique avec des caractéristiques de rhéofluidification extrudée par la buse d'extrusion forme les couches de circuit tridimensionnelles sur la surface supérieure du substrat.

2. Le procédé de préparation par impression tridimensionnelle du circuit imprimé multicouche de haute précision selon la revendication 1, **caractérisé en ce que**:
dans l'étape S1, la buse d'extrusion effectue un mouvement de pré-extrusion curviligne sur un plan perpendiculaire au substrat avant l'extrusion de la pâte métallique nanométrique avec des caractéristiques de de rhéofluidification par la buse d'extrusion pour former l'extrémité de départ de chaque circuit dans les couches de circuit tridimensionnelles, et la buse d'extrusion se déplace selon un trajet d'extrusion formel du circuit dans la direction de la tangente de la courbe ; et
dans l'étape S1, une section anti-projection prédéfinie est disposée à l'extrémité finale du trajet d'extrusion formel du circuit, et l'action d'extruder la pâte métallique nanométrique présentant des caractéristiques de rhéofluidification est coupée lorsque la buse d'extrusion est située à la section anti-projection.

3. Le procédé de préparation par impression tridimensionnelle du circuit imprimé multicouche de haute précision selon la revendication 1, **caractérisé en ce que**, dans l'étape S2, la pâte métallique nanométrique présentant des caractéristiques de rhéofluidification est extrudée de la buse d'extrusion, de manière à former alternativement des lignes de contour extérieur et des lignes de remplissage sur chaque couche des piliers métalliques, de sorte que le pilier métallique soit formé à la position prédéfinie de la couche de circuit tridimensionnelle courante par empilement.

4. Le procédé de préparation par impression tridimensionnelle du circuit imprimé multicouche de haute précision selon la revendication 1, **caractérisé en ce que**, dans l'étape S3, la méthode de formation de la couche isolante comprend:
appliquer un matériau isolant pré-appliqué sur une surface de revêtement à l'aide d'un outil de raclage ou extruder le matériau isolant sur la surface de revêtement à l'aide d'un outil de revêtement à fente, pour former la couche isolante sur la surface supérieure de la couche de circuit tridimensionnelle courante.

5. Le procédé de préparation par impression tridimensionnelle du circuit imprimé multicouche de haute précision selon la revendication 4, **caractérisé en ce que** l'étape S3 comprend également les étapes suivantes avant le revêtement de la couche isolante:
a. commander un moteur de l'axe Z pour faire descendre l'outil de revêtement de manière à ce que ses extrémités gauche et droite entrent en contact avec un capteur de contact ;
b. enregistrer les hauteurs différentes du moteur de l'axe Z lorsque les extrémités gauche et droite de l'outil de revêtement déclenchent le capteur de contact pour émettre des signaux, afin d'obtenir une différence de hauteur entre l'extrémité gauche et l'extrémité droite de l'outil de revêtement ; et
c. corriger les hauteurs de l'extrémité gauche et de l'extrémité droite de l'outil de revêtement en fonction de la différence de hauteur entre ces deux extrémités de l'outil de revêtement.

6. Le procédé de préparation par impression tridimensionnelle du circuit imprimé multicouche de haute précision selon la revendication 4, **caractérisé en ce que** l'étape S3 comprend également les étapes suivantes avant le revêtement de la couche isolante:
A. détecter la hauteur de la surface de contact du capteur de contact à l'aide d'un capteur de déplacement laser, pour obtenir la hauteur du capteur de contact ;
B. détecter la hauteur du point de départ du revêtement sur la surface de revêtement à l'aide du capteur de déplacement laser, pour obtenir la hauteur du point de départ du revêtement ;
C. calculer une différence de hauteur relative entre le capteur de contact et le point de départ du revêtement en fonction de la hauteur du capteur de contact et du point de départ du revêtement ;
D. faire en sorte que le centre de l'outil de revêtement, après correction de son inclinaison, entre en contact avec le capteur de contact, et enregistrer la hauteur de l'outil de revêtement sur l'axe Z lors du contact ; et
E. corriger la hauteur de l'outil de revêtement sur l'axe Z en fonction de la différence de hauteur relative entre le capteur de contact et le point de départ du revêtement, de la hauteur de l'outil de revêtement sur l'axe Z lors du contact avec le capteur de contact, et d'un écart de revêtement prédéfini.

7. Le procédé de préparation par impression tridimensionnelle du circuit imprimé multicouche de haute précision selon la revendication 1, **caractérisé en ce que** l'étape S3 comprend les étapes spécifiques suivantes:
S3.1. former la couche isolante sur la surface supérieure de la couche de circuit tridimensionnelle courante et
S3.2. faire émerger le pilier métallique correspondant hors de la couche isolante formée en perçant un trou dans la couche isolante et en remplissant le trou percé avec la pâte métallique nanométrique, conformément aux exigences de connexion des couches de circuit tridimensionnelles et à la hauteur du pilier métallique sur chaque couche de circuit tridimensionnelle.

8. Le procédé de préparation par impression tridimensionnelle du circuit imprimé multicouche de haute précision selon la revendication 1, **caractérisé en ce que** la pâte métallique nanométrique avec des caractéristiques de rhéofluidification comprend des nanoparticules d'argent ou de cuivre et un milieu dispersant, et que la teneur en nanoparticules métalliques varie de 75 % à 95 % ; la viscosité de la pâte métallique nanométrique avec des caractéristiques de rhéofluidification varie de 100 000 cps (100 Pa·s) à 1 000 000 cps (1 000 Pa·s), et un indice thixotrope varie de 4 à 10 ; et que le rapport hauteur-largeur de la ligne formée par la pâte métallique nanométrique avec des caractéristiques de rhéofluidification est d'au moins 0,5.

9. Le procédé de préparation par impression tridimensionnelle du circuit imprimé multicouche de haute précision selon la revendication 8, **caractérisé en ce que** le milieu dispersant comprend un solvant dispersant et un liant, et que le solvant dispersant comprend un ou plusieurs solvants organiques et de l'eau; et que le liant comprend un ou plusieurs des éléments suivants : un acide polyacrylique, une diéthanolamine et un complexe de l'acide polyacrylique et de la diéthanolamine ; ou que le liant comprend une résine époxy, un agent de durcissement et un agent protecteur.

10. Le procédé de préparation par impression tridimensionnelle du circuit imprimé multicouche de haute précision selon la revendication 9, **caractérisé en ce que** le solvant organique comprend un ou plusieurs des éléments suivants : éthylène glycol, glycérine, acétate de monoéthyléther de glycol diéthylène, ester dibasique, isophorone, terpinéol ou éther monobutyl de glycol diéthylène, l'agent protecteur étant formé par un ou une combinaison de plus d'un composé de trialkylphosphine et un composé de trialkylphosphine; la résine époxy comprend un ou plusieurs des éléments suivants : une résine époxy de type bisphénol A, une résine époxy E-44 et une résine époxy biphenoxy ; et l'agent de durcissement est l'un de suivants : un agent de durcissement polythiol, un agent de durcissement dicyandiamide et un agent de durcissement anhydride.

11. Le procédé de préparation par impression tridimensionnelle du circuit imprimé multicouche de haute précision selon la revendication 1, **caractérisé en ce que** la couche isolante est composée de diélectrique organique ou céramique.
